# EUROPEAN PATENT APPLICATION

(11) **EP 4 546 954 A1**
(43) Date of publication of application: **30.04.2025**
(21) Application number: 23831856.2
(22) Date of filing: 27.06.2023
(51) Int. Cl.: H05K 3/28, H05K 1/11, H05K 3/10, H01L 25/18, H01L 25/065, H01L 25/10, H01L 23/498, H01L 23/00

(54) **CIRCUIT BOARD AND SEMICONDUCTOR PACKAGE COMPRISING SAME**

(30) Priority: 27.06.2022 KR 20220078535
(71) Applicant: LG INNOTEK CO., LTD., Seoul 07796 (KR)
(72) Inventor: SEONG, Dae Hyeon, Seoul 07796 (KR); JEONG, In Ho, Seoul 07796 (KR); KWON, Soon Gyu, Seoul 07796 (KR); HWANG, Jung Ho, Seoul 07796 (KR)
(74) Representative: Plasseraud IP
(86) International application number: PCT/KR2023/008907
(87) International publication number: WO 2024/005496

(57) **Abstract**

A circuit board according to an embodiment comprises an insulating layer; a circuit pattern layer disposed on the insulating layer and including a pad; and a protective layer disposed on the insulating layer and including an opening vertically overlapping the pad, wherein the pad includes a recess concave from an upper surface of the pad toward a lower surface of the pad, wherein the protective layer includes a first region including the opening and vertically overlapping the pad, and a second region excluding the first region, wherein the pad includes a first portion including the recess; and a second portion connected to the first portion and not having the recess, wherein the first portion of the pad includes a first sub-portion vertically overlapping the opening of the protective layer, and a second sub-portion vertically overlapping a lower surface of the first region of the protective layer, and wherein a width of the second sub-portion of the pad is greater than a width of the second portion of the pad.

## Description

### [Technical Field]

The embodiment relates to a circuit board and a semiconductor package comprising the same.

### [Background Art]

High performance of electric/electronic products is progressing, and accordingly, technologies are being proposed and studied to attach a greater number of packages to a substrate of limited size.

A typical semiconductor package has a structure in which a plurality of chips are disposed. In addition, a size of the semiconductor package is increasing due to high specifications of products to which the semiconductor package is applied and an adoption of a plurality of chips such as HBM (High Bandwidth Memory). Accordingly, the semiconductor package includes an interposer to connect the plurality of chips.

In addition, semiconductor packages applied to products that provide the Internet of Things (IoT), autonomous vehicles, and high-performance servers, etc. require high performance and high reliability in line with a trend toward high integration. Here, high performance may include conditions such as high-speed transmission of signals, integration of semiconductor packages, and high allowable current of transmittable signals.

At this time, a size of a pad of the semiconductor package is decreasing for miniaturization and integration. The pad may be a mounting pad connected to the chip, and may be a bump pad connected to various substrates. Here, the various substrates may include additional packages such as a memory substrate, an interposer connecting between the chip and the circuit board, and a main board of an electronic device to which the semiconductor package is applied.

At this time, when a size of the pad is reduced, the integration of the semiconductor package can be improved. However, according to a conventional semiconductor package, a contact area between the pad and a solder bump is reduced in response to a reduction in the size of the pad, and thus, there is a problem that an adhesion between the pad and the solder bump is reduced. As a result, in a manufacturing process or usage environment of the semiconductor package, there is a problem of physical reliability and electrical reliability in which the solder bump is separated from the pad

(Patent Document 1) KR 10-2152865 B

### [Disclosure]

### [Technical Problem]

The embodiment provides a circuit board having a novel structure and a semiconductor package including the same.

In addition, the embodiment provides a circuit board with improved integration and a semiconductor package including the same.

In addition, the embodiment provides a circuit board capable of improving an adhesion between a pad and a connecting member and a semiconductor package including the same.

In addition, the embodiment provides a circuit board capable of increasing a contact area between a pad and a connecting member and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Problem]

A circuit board according to an embodiment comprises an insulating layer; a circuit pattern layer disposed on the insulating layer and including a pad; and a protective layer disposed on the insulating layer and including an opening vertically overlapping the pad, wherein the pad includes a recess concave from an upper surface of the pad toward a lower surface of the pad, wherein the protective layer includes a first region including the opening and vertically overlapping the pad, and a second region excluding the first region, wherein the pad includes a first portion including the recess; and a second portion connected to the first portion and not having the recess, wherein the first portion of the pad includes a first sub-portion vertically overlapping the opening of the protective layer, and a second sub-portion vertically overlapping a lower surface of the first region of the protective layer, and wherein a width of the second sub-portion of the pad is greater than a width of the second portion of the pad.

In addition, an upper surface of the second sub-portion of the pad is spaced apart from the lower surface of the first region of the protective layer, and an upper surface of the second portion of the pad is in direct contact with the lower surface of the first region of the protective layer.

In addition, an upper surface of the first portion of the pad has a concave-convex shape.

In addition, the width of the second sub-portion of the pad satisfies a range of 2 to 50 times the width of the second portion of the pad.

In addition, a vertical distance from the lower surface of the first region of the protective layer to an upper surface of the first portion of the pad satisfies a range of 5% to 55% of a vertical distance from the lower surface of the first region of the protective layer to a lower surface of the pad.

In addition, the pad includes a side surface, and at least a portion of an upper surface of the first portion of the pad is connected to the side surface of the pad.

In addition, the recess of the pad is connected to a side surface of the pad.

In addition, the pad includes a first side surface and a second side surface opposite to the first side surface, and a width of a second sub-portion of the pad adjacent to the first side surface of the pad is different from a width of a second sub-portion of the pad adjacent to the second side surface of the pad.

In addition, the recess includes a first part provided on an upper surface of the pad; and a second part provided on a side surface of the pad and connected to the first part.

In addition, a side surface of the pad having the second part is spaced apart from the protective layer.

In addition, the opening of the protective layer includes a region whose width changes in a vertical direction.

In addition, the circuit pattern layer further includes a trace disposed on the insulating layer, and an upper surface of the trace is positioned higher than an upper surface of the first portion of the pad.

Meanwhile, the semiconductor package according to the embodiment comprises an insulating layer; a pad disposed on the insulating layer and having a recess on an upper surface; a protective layer disposed on the insulating layer and including an opening vertically overlapping the pad; and a connecting member disposed to fill the opening of the protective layer and the recess of the pad, wherein an interface provided between the connecting member and the pad has a concave-convex shape, the protective layer includes a first region including the opening and vertically overlapping the pad and a second region excluding the first region, and the pad includes a first portion having the recess; and a second portion connected to the first portion and not having the recess, the first portion of the pad includes a first sub-portion vertically overlapping the opening of the protective layer, and a second sub-portion vertically overlapping a lower surface of the first region of the protective layer, and a width of the second sub-portion of the pad is larger than a width of the second portion of the pad.

In addition, the connecting member includes a portion disposed in the recess and in direct contact with the lower surface of the first region of the protective layer and an upper surface of the second sub-portion of the pad.

In addition, the recess is connected to at least a portion of the side surface of the pad, and the connecting member includes a portion disposed in the recess connected to the side surface of the pad and in direct contact with an inner surface of the second region of the protective layer.

In addition, the recess includes a first part provided on the upper surface of the pad, and a second part connected to the first part and provided on the side surface of the pad, and the connecting member includes a portion disposed in the first part and the second part of the recess and in contact with a lower surface of the first region of the protective layer, an inner surface of the second region of the protective layer, an upper surface of the first portion of the pad, and a side surface of the pad, respectively.

In addition, the semiconductor package further comprises a semiconductor device disposed on the connecting member.

In addition, the semiconductor package further comprises a substrate disposed on the connecting member.

In addition, the substrate includes at least one of an interposer connected to the semiconductor device, a memory substrate on which a memory chip is disposed, a main board of an electronic device, and a bridge substrate connecting between a plurality of semiconductor devices.

### [Advantageous Effects]

A circuit board and semiconductor package of the embodiment can improve an adhesion and a bonding strength between a pad and a connecting member. Therefore, the embodiment can solve a problem of cracks occurring in the connecting member, and thereby improve physical reliability and electrical reliability of the connecting member.

To this end, the circuit board of the embodiment includes an insulating layer, a pad, and a protective layer. The protective layer includes an opening vertically overlapping at least a portion of the pad. At this time, the protective layer includes a first region adjacent to the opening and vertically overlapping the pad, and a second region excluding the first region. In addition, the pad has a recess. The recess may be a concave portion that is concave from the upper surface of the pad toward the lower surface. The pad includes an upper surface having a concave-convex shape corresponding to the recess. At this time, the pad includes a first portion including the recess and a second portion that does not include the recess. At this time, the first portion of the pad includes a first sub-portion vertically overlapping the opening of the protective layer, and a second sub-portion vertically overlapping the first region of the protective layer. Meanwhile, a connecting member is disposed on the pad. At this time, the connecting member is disposed to fill the recess of the pad. Accordingly, the connecting member is disposed not only on the first sub-portion of the pad, but also on the second sub-portion. In addition, a part of the connecting member disposed on the second sub-portion may have a structure that is located between the lower surface of the first region of the protective layer and the upper surface of the second sub-portion of the pad.

Accordingly, the connecting member of the embodiment includes a first part disposed on the second sub-portion. In addition, the first part of the connecting member may function as an anchor that improves an adhesion and a bonding strength with the pad. Accordingly, the embodiment can solve a reliability problem of the connecting member being separated from the pad. Therefore, the embodiment can improve the overall product reliability of the circuit board and the semiconductor package.

In addition, the embodiment can improve a contact area between the pad and the connecting member through the anchor structure of the connecting member. Accordingly, the embodiment does not need to increase a size of the pad to improve the contact area. Accordingly, the embodiment can reduce a size of the pad, thereby improving a circuit integration. Furthermore, the embodiment can reduce an overall volume of the circuit board and the semiconductor package.

Meanwhile, the recess provided in the pad of the embodiment can include a plurality of parts. For example, the recess can include a first part provided on the upper surface of the pad and a second part connected to the first part and provided on the side surface of the pad.

Therefore, at least a part of the side surface of the pad can't be in contact with the protective layer through the second part of the recess. In addition, the connecting member can be disposed in the second part of the recess of the pad. The connecting member can be disposed in the first part of the recess and can be in contact with a lower surface of the first region of the protective layer and an upper surface of the pad. In addition, the connecting member may be positioned within the second part of the recess to be in contact with an inner surface of the second region of the protective layer and a side surface of the pad. Accordingly, the embodiment may further increase a contact area between the pad and the connecting member. Accordingly, the embodiment may further improve the adhesion and bonding strength between the pad and the connecting member.

### [Description of Drawings]

FIG. 1a is a cross-sectional view showing a circuit board according to a comparative example.
FIG. 1b is a view showing a scanning electron microscope photograph of an actual product of FIG. 1a.
FIG. 2a is a view showing a semiconductor package according to a first embodiment.
FIG. 2b is a view showing a semiconductor package according to a second embodiment.
FIG. 2c is a view showing a semiconductor package according to a third embodiment.
FIG. 2d is a view showing a semiconductor package according to a fourth embodiment.
FIG. 2e is a view showing a semiconductor package according to a fifth embodiment.
FIG. 2f is a view showing a semiconductor package according to a sixth embodiment.
FIG. 3 is a cross-sectional view showing a circuit board according to an embodiment.
FIG. 4a is an enlarged cross-sectional view of a part of a circuit board according to a first embodiment.
FIG. 4b is a plan view of the circuit board of FIG. 4a.
FIG. 4c is a cross-sectional view showing a state in which a connecting member is disposed on the circuit board of FIG. 4a.
FIG. 5a is a view showing a first modified example of the circuit board of FIG. 4a.
FIG. 5b is a view showing a second modified example of the circuit board of FIG. 4a.
FIG. 6 is a cross-sectional view showing a circuit board of a second embodiment.
FIG. 7 is a cross-sectional view showing a circuit board of a third embodiment.
FIG. 8a is a drawing showing a circuit board according to a fourth embodiment.
FIG. 8b is a cross-sectional view showing a state in which a connecting member is disposed on the circuit board of FIG. 8a.
FIG. 9 is a cross-sectional view showing a circuit board according to a fifth embodiment.
FIGS. 10a to 10d are cross-sectional views for explaining a manufacturing method of the circuit board illustrated in Figure 3 in orders of processes.

### [Mode for Invention]

Hereinafter, embodiments of the present disclosure will be described in detail with reference to the accompanying drawings.

However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C". Further, in describing the elements of the embodiments of the present disclosure, the terms such as first, second, A, B, (a), and (b) may be used.

These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

### - Comparative (Structure of Prior Art and Problems of Prior Art) -

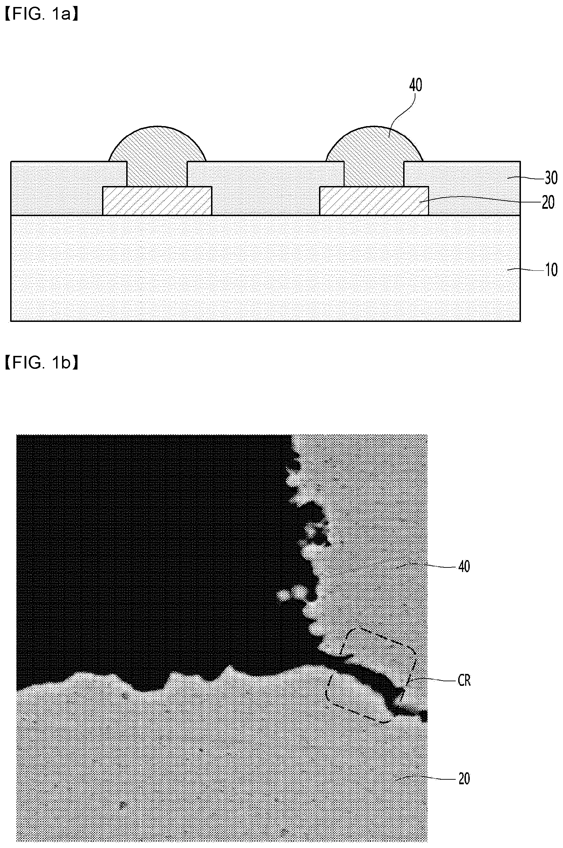

FIG. 1a is a cross-sectional view showing a circuit board according to a comparative example, and FIG. 1b is a view showing a scanning electron microscope photograph of an actual product of FIG. 1a.

Referring to FIG. 1a, the circuit board of the comparative example includes an insulating layer 10, a pad 20, a protective layer 30, and a connecting member 40.

The circuit board of the comparative example includes a pad 20 disposed on the insulating layer 10. The pad 20 is one of a first pad on which a chip is mounted and a second pad coupled to an external substrate.

In addition, a protective layer 30 includes an opening vertically overlapping the pad 20, and is disposed on the insulating layer 10. The protective layer 30 includes an opening formed corresponding to a region where the connecting member 40 is disposed.

The connecting member 40 is disposed on the pad 20. Specifically, the connecting member 40 is disposed on the pad 20 vertically overlapping with the opening of the protective layer 30.

At this time, a contact area between the connecting member 40 and the pad 20 of the comparative example corresponds to an area of the opening of the protective layer 30.

Specifically, the contact area between the connecting member 40 and the pad 20 of the comparative example is determined by an area of the opening of the protective layer 30 vertically overlapping with the pad 20. The contact area between the connecting member 40 and the pad 20 is equal to an area of the opening of the protective layer 30 vertically overlapping with the pad 20.

Accordingly, the comparative example increases an area of the opening of the protective layer 30 to increase the contact area between the connecting member 40 and the pad 20. However, when the area of the opening of the protective layer 30 increases, a size of the pad 20 must increase accordingly. In addition, when the size of the pad 20 increases, there is a problem that the circuit integration decreases.

Meanwhile, in the comparative example, a size of the pad 20 is reduced to improve the circuit integration, and an area of the opening of the protective layer 30 is also reduced accordingly.

However, when the area of the opening of the protective layer 30 is reduced, the contact area between the connecting member 40 and the pad 20 is reduced accordingly. In addition, when the contact area between the connecting member 40 and the pad 20 is reduced, a problem of physical reliability or electrical reliability of the connecting member 40 occurs in a manufacturing environment of the semiconductor package or an usage environment of the semiconductor package.

Specifically, referring to FIG. 1b, when the contact area between the connecting member 40 and the pad 20 is reduced, there is a problem that a crack occurs at an interface CR between the connecting member 40 and the pad 20. In, the connecting member 40 may be separated from the pad 20 by the crack, and thus, physical reliability and electrical reliability problems of the semiconductor package may occur.

For example, thermal stress may occur in the usage environment or manufacturing environment of the semiconductor package, and the thermal stress may be concentrated on the interface between the connecting member 40 and the pad 20. In addition, when the thermal stress is concentrated on the interface, a crack occurrence rate at the interface may increase.

### - Electronic device -

Before describing an embodiment, an electronic device to which a semiconductor package of the embodiment is applied will be briefly described. The electronic device includes a main board (not shown). The main board may be physically and/or electrically connected to various components. For example, the main board may be connected with the semiconductor package of the embodiment. In addition, various semiconductor devices can be mounted in the semiconductor package.

The semiconductor device may include an active device and/or a passive device, and have various functions. The active device may be a semiconductor device in the form of an integrated circuit (IC) in which hundreds to millions of devices are integrated into a single chip. The semiconductor device may be a logic chip, a memory chip, or the like. The logic chip may be a central processor (CPU), a graphic processor (GPU), or the like. For example, the logic chip may be an application processor (AP) semiconductor device including at least one of a central processor (CPU), a graphic processor (GPU), a digital signal processor, a cryptographic processor, a microprocessor, and a microcontroller, or an analog-to-digital converter, an application-specific IC (ASIC), etc., or a chip set that includes a specific combination of those listed so far.

The memory chip may be a stack memory such as HBM. Also, the memory chip may include a memory chip such as a volatile memory (eg, DRAM), a non-volatile memory (eg, ROM), or a flash memory.

A product group to which the semiconductor package of the embodiment is applied include CSP (Chip Scale Package), FC-CSP (Flip Chip-Chip Scale Package), FC-BGA (Flip Chip Ball Grid Array), POP (Package On Package), and SIP ( System In Package), but is not limited thereto.

In addition, the electronic device may include a smart phone, a personal digital assistant, a digital video camera, a digital still camera, a network system, a computer, a monitor, a tablet, a laptop, a netbook, a television, a video game, a smart watch, an automotive, and the like. However, the embodiment is not limited thereto, and may be any other electronic device that processes data in addition to these.

Hereinafter, a semiconductor package including a circuit board according to an embodiment will be described. The semiconductor package of the embodiment may have various package structures including a circuit board to be described later.

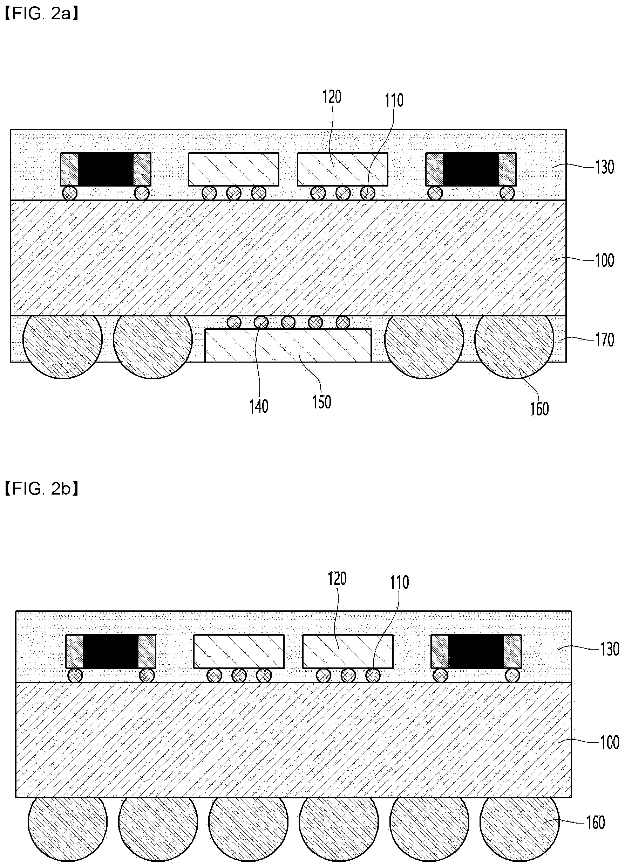

FIG. 2a is a view showing a semiconductor package according to a first embodiment.

Referring to FIG. 2a, a semiconductor package of a first embodiment includes a first substrate 100.

The first substrate 100 may mean a package substrate.

For example, the first substrate 100 may provide a space to which at least one external substrate is coupled. For example, the first substrate 100 may provide a space to which a main board included in an electronic device is coupled.

As described below, the first substrate 100 may include at least one insulating layer, a circuit pattern layer disposed on the at least one insulating layer, a through electrode penetrating the at least one insulating layer, and a protective layer protecting the insulating layer and the circuit pattern layer.

The first substrate 100 may include a plurality of pads. Here, the plurality of pads may mean a part of the circuit pattern layer disposed on an outermost layer of the first substrate 100. For example, the pad may mean a part of the circuit pattern layer disposed on an uppermost side of the first substrate 100. For example, the pad may mean a part of the circuit pattern layer disposed on a lowermost side of the first substrate 100. In addition, the protective layer may include an opening that exposes a surface (e.g., an upper surface or a lower surface) of the pad.

Meanwhile, the semiconductor package may include a plurality of connecting members.

For example, the first substrate 100 may include a plurality of pads, and the plurality of connecting members may be respectively disposed on the plurality of pads.

Specifically, the first substrate 100 may include a plurality of first pads. In addition, the semiconductor package may include a first connecting member 110 disposed on the plurality of first pads.

In addition, the first substrate 100 may include a plurality of second pads. In addition, the semiconductor package may include a second connecting member 140 disposed on the plurality of second pads.

In addition, the first substrate 100 may include a plurality of third pads. In addition, the semiconductor package may include a third connecting member 160 disposed on the plurality of third pads.

At this time, the first pad may be disposed on an upper surface of the first substrate 100. In addition, the second and third pads may be disposed on a lower surface of the first substrate 100.

Meanwhile, the semiconductor package may include a plurality of semiconductor devices.

For example, the semiconductor package may include a first semiconductor device 120 disposed on the first connecting member 110. At this time, the first pads of the first substrate 100 may be divided into a plurality of groups. In addition, the first connecting member 110 may be disposed on each of the first pads of the plurality of groups. In addition, the first semiconductor device 120 may be mounted on each of the first pads of the plurality of groups. Accordingly, the first semiconductor device 120 may be mounted on an upper side of the first substrate 100 at a predetermined spacing from each other. At this time, the first semiconductor device 120 may refer to a semiconductor device mounted on an upper side of the first substrate 100. In addition, a plurality of first semiconductor devices may be disposed on the upper side of the first substrate 100 at a predetermined spacing from each other.

In addition, the semiconductor package may include a second semiconductor device 140 disposed under the second connecting member 140. The second semiconductor device 140 may refer to a semiconductor device mounted on a lower side of the first substrate 100 among the semiconductor devices included in the semiconductor package. In addition, a plurality of second semiconductor devices may be disposed on the lower side of the first substrate 100 at a predetermined spacing from each other.

In this time, at least one of the first semiconductor device 120 and the second semiconductor device 140 may include a logic chip. For example, at least one of the first semiconductor device 120 and the second semiconductor device 140 may include an application processor chip. For example, at least one of the first semiconductor device 120 and the second semiconductor device 140 may include an analog-to-digital converter or an ASIC (application-specific IC). For example, at least one of the first semiconductor device 120 and the second semiconductor device 140 may include a memory chip. The memory chip may be a stack memory such as HBM. For example, the memory chip may include a volatile memory (e.g., DRAM), a non-volatile memory (e.g., ROM), a flash memory, etc.

In addition, at least one of the first semiconductor device 120 and the second semiconductor device 140 may include at least one of a drive IC chip, a diode chip, a power IC chip, a touch sensor IC chip, an MLCC (Multi layer ceramic condenser) chip, a BGA (Ball Grid Array) chip, and a chip condenser.

In addition, the semiconductor package may include a third connecting member 160. The third connecting member 160 may be positioned under the third pad of the first substrate 100. The third connecting member 160 may connect between the first substrate 100 and a main board of an electronic device. The third connecting member 160 may have a larger diameter than the first connecting member 110 and the second connecting member 140. For example, a diameter of the third connecting member 160 may satisfy a range of 10 to 200 times a diameter of at least one of the first connecting member 110 and the second connecting member 140. For example, the diameter of the third connecting member 160 may satisfy a range of 20 to 180 times the diameter of at least one of the first connecting member 110 and the second connecting member 140. For example, the diameter of the third connecting member 160 may satisfy a range of 40 to 150 times the diameter of at least one of the first connecting member 110 and the second connecting member 140. That is, the third connecting member 160 is connected to the main board of the electronic device and may have a larger diameter than the other connecting members to correspond to a width of a pad part of the main board. In addition, the first connecting member 110 and the second connecting member 140 are connected to the semiconductor device and may have a smaller diameter than the third connecting member 160 to correspond to a terminal of the semiconductor device.

The semiconductor package may include a molding layer.

For example, the semiconductor package may include a first molding layer 130 disposed on the first substrate 100. The first molding layer 130 may mold components disposed on an outermost layer of the first substrate 100. For example, the first molding layer 130 can mold a surface of the protective layer, a surface of the circuit pattern layer, and a surface of the insulating layer disposed on an uppermost side of the first substrate 100. In addition, the first molding layer 130 can mold the first connecting member 110 and the first semiconductor device 120 disposed on the first substrate 100. At this time, the semiconductor package can further include an underfill (not shown) surrounding the first connecting member 110 and the first semiconductor device 120. In addition, when the semiconductor package includes the underfill, the first molding layer 130 can mold a periphery of the underfill.

In addition, the semiconductor package may include a second molding layer 170 disposed under the first substrate 100. The second molding layer 170 may mold a surface of the protective layer, a surface of the circuit pattern layer, and a surface of the insulating layer disposed on a lowermost side of the first substrate 100. In addition, the second molding layer 170 may mold the second connecting member 140 and the second semiconductor device 140 disposed under the first substrate 100. In addition, the second molding layer 170 may mold the third connecting member 160.

At this time, the second molding layer 170 may expose at least a portion of a lower surface of the second semiconductor device 140. For example, a lower surface of the second molding layer 170 may be positioned not lower than a lower surface of the second semiconductor device 140. For example, the lower surface of the second molding layer 170 may be positioned on a same plane as the lower surface of the second semiconductor device 140.

In addition, the second molding layer 170 may be positioned not lower than the lower surface of the third connecting member 160. For example, the lower surface of the second molding layer 170 may be positioned on a same plane as the lower surface of the third connecting member 160 or higher than the lower surface of the third connecting member 160. Therefore, the lower surface of the third connecting member 160 may not be covered by the second molding layer 170. In addition, at least a portion of the third connecting member 160 may protrude downward from the second molding layer 170.

The first molding layer 130 and the second molding layer 170 may be an EMC (Epoxy Mold Compound), but are not limited thereto. The first molding layer 130 and the second molding layer 170 may have a low permittivity. For example, the permittivity (Dk) of the first molding layer 130 and the second molding layer 170 may be 0.2 to 10. For example, the permittivity (Dk) of the first molding layer 130 and the second molding layer 170 may be 0.5 to 8. For example, the permittivity (Dk) of the first molding layer 130 and the second molding layer 170 may be 0.8 to 5. Accordingly, in the embodiment, the heat dissipation characteristics of heat generated from the first semiconductor device 120 and the second semiconductor device 140 may be improved by making the first molding layer 130 and the second molding layer 170 have low permittivity. The semiconductor package of the first embodiment may have a double-sided molding structure as described above.

That is, the semiconductor package of the first embodiment may have a structure in which at least one first semiconductor device 120 and a second semiconductor device 140 are mounted on the upper and lower sides of the first substrate 100, respectively.

FIG. 2b is a view showing a semiconductor package according to a second embodiment.

Referring to FIG. 2b, the semiconductor package according to the second embodiment may differ from the semiconductor package of the first embodiment of FIG. 1a in that the semiconductor package has a one-sided molding structure.

For example, the semiconductor package of the second embodiment may include a first substrate 100, a first connecting member 110, a first semiconductor device 120, a first molding layer 130, and a third connecting member 160.

In addition, the semiconductor package of the second embodiment may have a structure in which the semiconductor device is mounted only on the upper side of the first substrate 100. Accordingly, the molding layer of the semiconductor package of the second embodiment may be disposed only on the upper side of the first substrate 100.

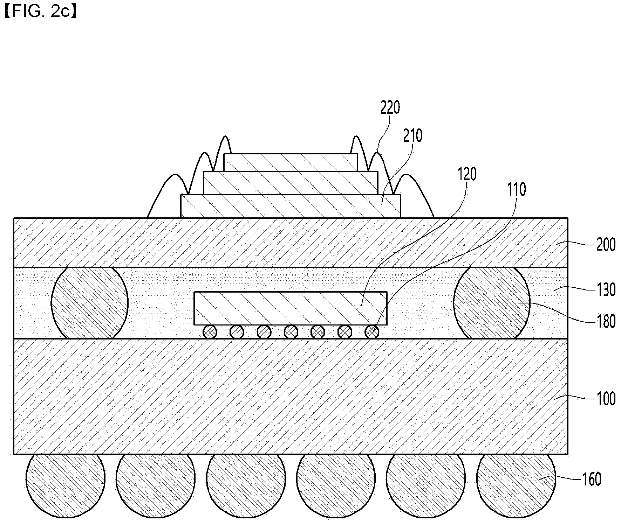

FIG. 2c is a view showing a semiconductor package according to a third embodiment.

Referring to FIG. 2c, the semiconductor package according to the third embodiment is different from the semiconductor package of the second embodiment of FIG. 1b in that the semiconductor package further includes an additional package.

The semiconductor package of the third embodiment may further include a fourth pad disposed on an upper side of the first substrate 100. That is, a circuit pattern layer is disposed on an upper surface of the first substrate 100. In addition, a part of the circuit pattern layer may function as a first pad on which the first semiconductor device 120 is mounted, and another part may function as a fourth pad.

The semiconductor package of the third embodiment may further include a fourth connecting member 180 disposed on the fourth pad.

An upper surface of the fourth connecting member 180 may not be covered with the first molding layer 130.

The semiconductor package of the third embodiment may include a second substrate 200 disposed on the fourth connecting member 180. The second substrate 200 may be a memory substrate, but is not limited thereto.

The semiconductor package of the third embodiment may include a third semiconductor device 210 mounted on the second substrate 200. The third semiconductor device 210 may be a memory chip, but is not limited thereto.

In addition, the semiconductor package of the third embodiment may further include a connection member 220 connecting the second substrate 200 and the third semiconductor device 210. That is, the semiconductor package of the third embodiment of FIG. 2c may have a package-on-package structure.

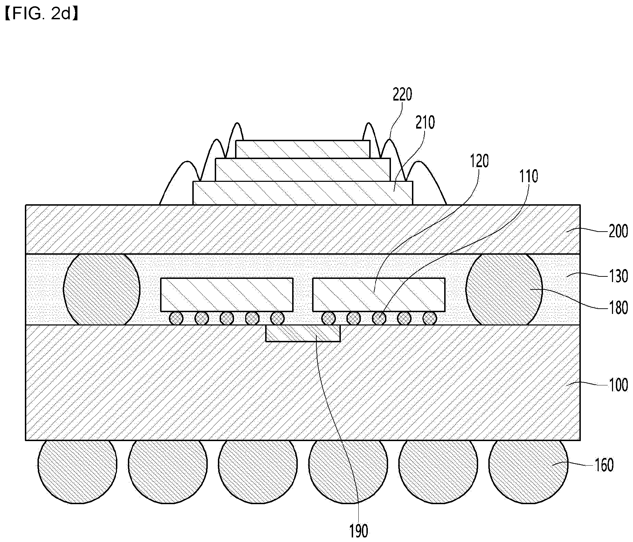

FIG. 2d is a view showing a semiconductor package according to a fourth embodiment.

Referring to FIG. 2d, the semiconductor package according to the fourth embodiment is different from the semiconductor package of the third embodiment of FIG. 2c in that the first semiconductor device 120 includes a plurality of logic chips and an additional third substrate 190 is disposed on the first substrate 100.

For example, a plurality of logic chips may be disposed on the first substrate 100. For example, a plurality of logic chips of the same type may be disposed on the first substrate 100, or, differently, a plurality of logic chips of different types may be disposed.

At this time, a connection member may be disposed on the first substrate 100 to connect the plurality of first semiconductor devices 120. The connection member may mean a third substrate 190.

The third substrate 190 may be a bridge substrate. The third substrate 190 may include a redistribution layer. The third substrate 190 is disposed on the first substrate 100. In addition, the third substrate 190 can electrically connect a plurality of first semiconductor devices 120 corresponding to a plurality of logic chips. At this time, although the drawing illustrates that the third substrate 190 is embedded in the first substrate 100, the embodiment is not limited thereto. For example, the third substrate 190 may be disposed on the first substrate 100.

The third substrate 190 may be a silicon bridge substrate. Alternatively, the third substrate 190 may be an organic bridge including an organic material.

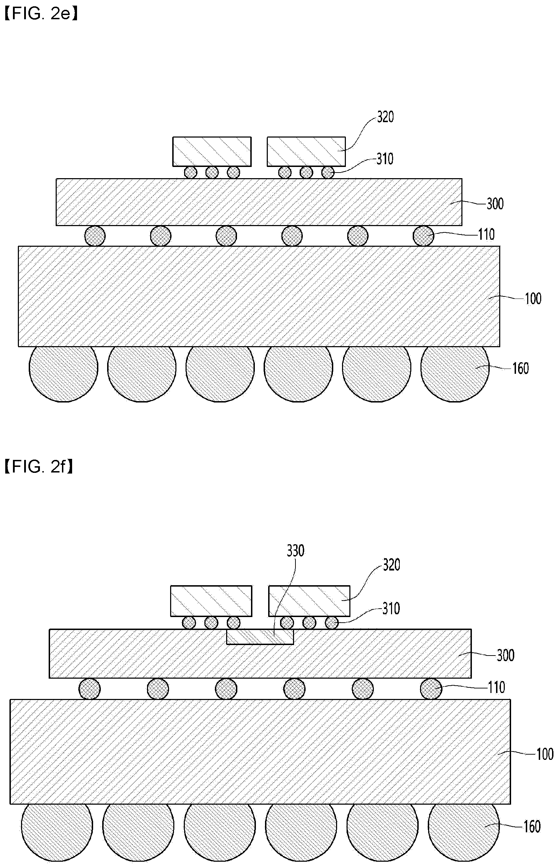

FIG. 2e is a view showing a semiconductor package according to a fifth embodiment.

Referring to FIG. 2e, the semiconductor package according to the fifth embodiment is different from the semiconductor package of the previous embodiment in that a fourth substrate 300 is disposed between the first substrate and the first semiconductor device.

The semiconductor package according to the fifth embodiment may include a fourth substrate 300 disposed on the first substrate 100.

To this end, a first connecting member 110 connecting the first substrate 100 and the fourth substrate 300 may be disposed on the first substrate 100.

In addition, the semiconductor package according to the fifth embodiment may include a fifth connecting member 320 disposed on the fourth substrate 300. In addition, the semiconductor package according to the fifth embodiment may include a semiconductor device 320 disposed on the fifth connecting member 320. The semiconductor device 320 may be provided as one, or the semiconductor device 320 may be provided in plural.

Meanwhile, the fourth substrate 300 may be disposed between the first substrate 100 and the semiconductor device 320. The fourth substrate 300 may perform a function of connecting the first substrate 100 and the semiconductor device 320. In addition, the fourth substrate 300 may perform a function of connecting a plurality of semiconductor devices 320.

At this time, the fourth substrate 300 may also be referred to as an interposer connecting the first substrate 100 and the semiconductor device 320.

In one embodiment, the fourth substrate 300 may be an active interposer that functions as a semiconductor device. When the fourth substrate 300 functions as a semiconductor device, a package of the fifth embodiment can have a structure in which a plurality of logic chips having a vertically stacked structure are mounted on the first substrate 100. In addition, a first logic chip corresponding to the active interposer among the logic chips can perform a function of the corresponding logic chip while performing a signal transmission function between a second logic chip disposed on an upper side thereof and the first substrate 100.

According to another embodiment, the fourth substrate 300 may be a passive interposer. For example, the fourth substrate 300 may perform a signal relay function between the semiconductor device 320 and the first substrate 100. For example, a number of terminals in the semiconductor device 320 is gradually increasing due to reasons such as 5G, the Internet of Things (IOT), increased image quality, and increased communication speed. That is, a number of terminals provided in the semiconductor device 320 is increasing, and thus a width of the terminal or a spacing between the plurality of terminals is decreasing. At this time, the first substrate 100 is connected to the main board of the electronic device. Accordingly, in order for the pads provided on the first substrate 100 to have a width and spacing for being connected to the semiconductor device 320 and the main board, respectively, there is a problem that a thickness of the first substrate 100 increases or a layer structure of the first substrate 100 becomes complicated. Therefore, the fourth substrate 300 may be disposed between the first substrate 100 and the semiconductor device 320. The fourth substrate 300 may include pads having a micro width and spacing corresponding to the terminals of the semiconductor device 320.

FIG. 2f is a view showing a semiconductor package according to a sixth embodiment.

Referring to FIG. 2f, the semiconductor package according to the sixth embodiment is different from the semiconductor package of the fifth embodiment in that a fifth substrate 330 is additionally disposed on the fourth substrate 300.

A plurality of semiconductor devices 320 that are horizontally spaced from each other may be disposed on the fourth substrate 300. In addition, the plurality of semiconductor devices 320 may be different types or a same type of active devices. For example, a plurality of semiconductor devices 320 may mean different types of AP chips. In addition, one of the plurality of semiconductor devices 320 may be an AP chip, and another chip may be a memory chip.

In addition, the semiconductor package of the sixth embodiment further includes a fifth substrate 330. The fifth substrate 330 may be embedded in the fourth substrate 300, but is not limited thereto. For example, the fifth substrate 330 may be disposed on the fourth substrate 300 and may perform a function of connecting the plurality of semiconductor devices 320.

The fifth substrate 330 may include a redistribution layer. For example, the fifth substrate 330 may be a bridge. The fifth substrate 330 may include a silicon bridge. Differently, the fifth substrate 330 may be an organic bridge including an organic material.

Meanwhile, each of the semiconductor packages of the first to sixth embodiments includes a connecting member as described above.

At this time, the connecting member may be a member that functions to electrically connect a plurality of components using at least one bonding method among wire bonding, solder bonding, and direct metal bonding.

That is, since the connecting member has a function to electrically connect a plurality of components, when direct metal bonding is used, the connecting member may be understood as a part that is electrically connected, not a solder or a wire.

The wire bonding method may mean electrically connecting a plurality of components using a conductor such as gold (Au). In addition, the solder bonding method may electrically connect a plurality of components using a material including at least one of Sn, Ag, and Cu. In addition, the direct metal bonding method may mean directly bonding a plurality of components by applying heat and pressure between the plurality of components without a member such as solder, wire, or conductive adhesive to recrystallize the plurality of components. In addition, the direct bonding method between metals may mean a connecting member connecting a substrate and a semiconductor device. At this time, the connecting member of the direct bonding method may mean a metal layer formed between a plurality of components by the recrystallization.

Hereinafter, a circuit board of an embodiment will be described.

Before describing the circuit board of an embodiment, the circuit board described below may mean any one of a plurality of substrates included in a previous semiconductor package.

For example, a circuit board described below may mean a first substrate 100 included in the semiconductor package of FIGS. 2a to 2c. In addition, when the circuit board means the first substrate 100, a pad described below may mean any one of a first pad on which the first connecting member 110 is disposed, a second pad on which the second connecting member 140 is disposed, and a third pad on which the third connecting member 160 is disposed.

In addition, a circuit board described below may mean the first substrate 100 included in the semiconductor package of FIG. 2d, or alternatively, may mean the second substrate 200, or alternatively, may mean the third substrate 190.

In addition, a circuit board described below may mean the first substrate 100 included in the semiconductor package of FIG. 2e, and alternatively, may mean the fourth substrate 300.

In addition, a circuit board described below may mean the first substrate 100 included in the semiconductor package of FIG. 2f, or alternatively, may mean the fourth substrate 300, or alternatively, may mean the fifth substrate 330.

That is, the circuit board of the embodiment is characterized by a structure of the pad on which the connecting member is disposed. In one embodiment, the pad on which the connecting member is disposed may be a pad connected to a semiconductor device. In another embodiment, a pad on which the connecting member is disposed may be a pad connected to a main board of an electronic device. In another embodiment, a pad on which the connecting member is disposed may mean a pad connected to the fourth substrate 300. In another embodiment, a pad on which the connecting member is disposed may mean a pad connected to the fifth substrate 330.

In summary, a pad of the circuit board described below may mean one or more of a plurality of pads included in the first substrate 100. Alternatively, a pad of the circuit board described below may mean one or more of a plurality of pads included in the second substrate 200. Alternatively, a pad of the circuit board described below may mean one or more of a plurality of pads included in the third substrate 190. Alternatively, a pad of the circuit board described below may mean one or more of a plurality of pads included in the fourth substrate 300. Alternatively, a pad of the circuit board described below may mean one or more of a plurality of pads included in the fifth substrate 330.

Hereinafter, the circuit board of the embodiment is described as being the first substrate 100 of the semiconductor package of the third embodiment illustrated in FIG. 2c.

Accordingly, as an example, a pad described below may mean a first pad connected to a first semiconductor device 120, and a connecting member described below may mean a first connecting member 110 connecting between the first semiconductor device 120 and the first pad.

As another example, a pad described below may mean a second pad connected to a second substrate 200, and the connecting member described below may mean a fourth connecting member 180 connecting between the second substrate 200 and the second pad.

As another example, a pad described below may mean a third pad connected to a main board of an electronic device, and the connecting member described below may mean a third connecting member 160 connecting between the main board and the third pad.

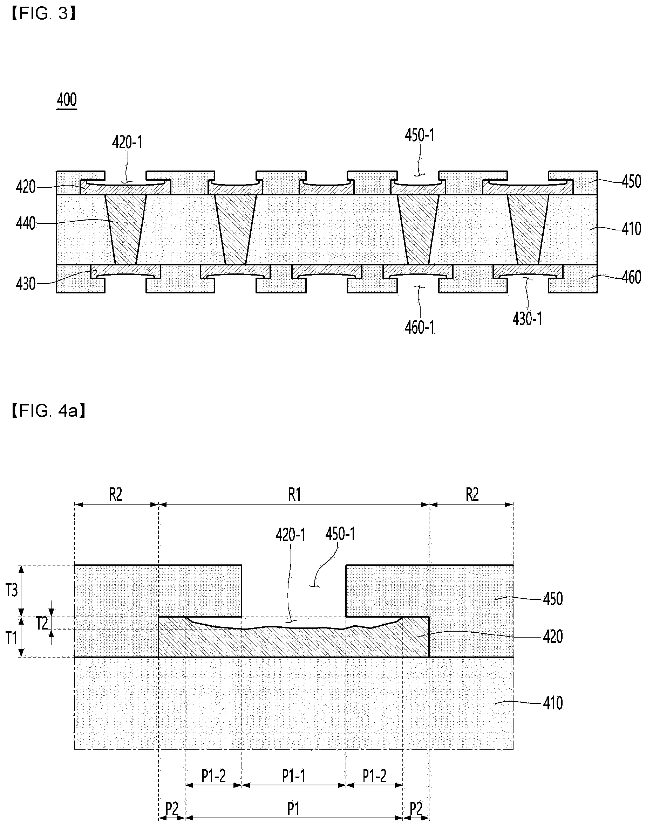

FIG. 3 is a cross-sectional view showing a circuit board according to an embodiment.

Referring to FIG. 3, the circuit board 400 includes an insulating layer 410.

The insulating layer 410 may have one or more layers. Preferably, the insulating layer 410 may have a multilayer structure.

However, although the insulating layer 410 of the circuit board 400 is illustrated as having a one-layer structure in the drawing, the embodiment is not limited thereto. For example, the insulating layer 410 may have a structure in which a plurality of layers are laminated in a vertical direction. Preferably, the circuit board 400 may have a multilayer structure of at least two or more layers.

For convenience of explanation, a following description will be made assuming that the insulating layer of the circuit board 400 consists of one layer.

The insulating layer 410 may be rigid or flexible.

For example, the insulating layer 410 may include a prepreg. For example, the insulating layer 410 may be a prepreg in which glass fibers are impregnated in a resin. The resin may be an epoxy resin, but is not limited thereto.

In addition, the insulating layer 410 may include chemically strengthened/semi-strengthened glass such as soda lime glass or aluminosilicate glass. For example, the insulating layer 410 may include a strengthened or flexible plastic such as polyimide (PI), polyethylene terephthalate (PET), propylene glycol (PPG), or polycarbonate (PC). For example, the insulating layer 410 may include sapphire. For example, the insulating layer 410 may include an optically isotropic film. For example, the insulating layer 410 may include COC (Cyclic Olefin Copolymer), COP (Cyclic Olefin Polymer), photo isotropic polycarbonate (PC), or photo isotropic polymethyl methacrylate (PMMA). For example, the insulating layer 410 may be formed of a material including an inorganic filler and an insulating resin. For example, the insulating layer 410 may have a structure in which an inorganic filler of silica or alumina is disposed in a thermosetting resin or a thermoplastic resin. For example, the insulating layer 410 may use ABF (Ajinomoto Build-up Film), FR-4, BT (Bismaleimide Triazine), PID (Photo Imageable Dielectric resin), BT, etc. For example, the insulating layer 410 may include RCC (Resin coated copper).

The insulating layer 410 may have a thickness in a range of 10 µm to 60 µm. For example, when the insulating layer 410 includes a plurality of layers, each of the plurality of layers may have a thickness in a range of 10 µm to 60 µm. Preferably, the insulating layer 410 may have a thickness in a range of 15 µm to 55 µm. More preferably, the insulating layer 410 may have a thickness in a range of 18 µm to 52 µm.

The thickness of the insulating layer 410 may mean a vertical distance between a plurality of circuit pattern layers disposed adjacent to each other in a thickness direction. For example, the thickness of the insulating layer 410 may mean a vertical distance between the first circuit pattern layer 420 and the second circuit pattern layer 430. For example, the thickness of the insulating layer 410 may mean a vertical distance between a lower surface of the first circuit pattern layer 420 and an upper surface of the second circuit pattern layer 430.

If the thickness of the insulating layer 410 is less than 10um, warpage characteristics of the circuit board 400 may be deteriorated. For example, if the thickness of the insulating layer 410 is less than 10um, the first circuit pattern layer 420 and the second circuit pattern layer 430 disposed on the surface of the insulating layer 410 may not be stably protected, and thus, electrical reliability and/or physical reliability problems may occur. In addition, if the thickness of the insulating layer 410 is less than 10um, a processability in a process of forming the first circuit pattern layer 420 or the second circuit pattern layer 430 on the insulating layer 410 may be deteriorated.

In addition, if the thickness of the insulating layer 410 exceeds 60um, an overall thickness of the circuit board 400 may increase, and thus a thickness of the semiconductor package may increase. In addition, if the thickness of the insulating layer 410 exceeds 60um, it may be difficult to miniaturize the first circuit pattern layer and/or the second circuit pattern layer 430. For example, if the thickness of the insulating layer 410 exceeds 60um, it may be difficult to form a width of the first circuit pattern layer and/or the second circuit pattern layer 430 and a spacing between adjacent patterns to 12um or less, 10um or less, 8um or less, or 6um or less. In addition, if it is difficult to miniaturize the first circuit pattern layer and/or the second circuit pattern layer 430, the circuit integration may decrease, and accordingly, a signal transmission distance may increase, which may increase a signal transmission loss.

Meanwhile, if the circuit board 400 of the embodiment has a multilayer structure, at least one of the plurality of insulating layers may include an insulating material different from that of at least one another insulating layer. For example, when the circuit board 400 includes a plurality of insulating layers, at least one insulating layer may be an insulating layer including reinforcing fibers, and at least one another insulating layer may be an insulating layer not including reinforcing fibers. In addition, the insulating layer including the reinforcing fibers may be a core layer. Accordingly, the circuit board 400 may be a core substrate including a core layer, but is not limited thereto.

In addition, when the circuit board 400 is a core substrate, a thickness of the insulating layer 410 described above may mean a thickness of an insulating layer not including the reinforcing fibers.

The circuit board 400 includes a circuit pattern layer disposed on the insulating layer 410.

For example, the circuit board 400 includes a first circuit pattern layer 420 disposed on an upper surface of the insulating layer 410. In addition, the circuit board 400 includes a second circuit pattern layer 430 disposed on a lower surface of the insulating layer 410.

The first circuit pattern layer 420 may be divided into a plurality of circuit patterns according to positions or functions. For example, the first circuit pattern layer 420 may include at least one pad. For example, the first circuit pattern layer 420 may include a pad on which a semiconductor device is mounted. For example, the first circuit pattern layer 420 may include a pad to which an external substrate is coupled. As an example, the first circuit pattern layer 420 may include a pad coupled with an interposer. As another example, the first circuit pattern layer 420 may include a pad coupled with a bridge substrate. As another example, the first circuit pattern layer 420 may include a pad coupled with a memory substrate including a memory chip.

The first circuit pattern layer 420 may refer to a first outermost circuit pattern layer of a circuit board 400. Specifically, when the circuit board 400 has a multilayer structure including a plurality of insulating layers, the first circuit pattern layer 420 may refer to a circuit pattern layer disposed on an upper surface of an insulating layer disposed at an uppermost side among the plurality of insulating layers.

The first circuit pattern layer 420 may include a plurality of metal layers. For example, the first circuit pattern layer 420 may include a first metal layer disposed on an upper surface of the insulating layer 410 and a second metal layer disposed on the first metal layer. The first metal layer of the first circuit pattern layer 420 may be a seed layer for electroplating the second metal layer of the first circuit pattern layer 420. A thickness of the first metal layer of the first circuit pattern layer 420 may satisfy a range of 0.2 um to 3.0 um. Preferably, a thickness of the first metal layer of the first circuit pattern layer 420 may satisfy a range of 0.3 um to 2.8 um. More preferably, the thickness of the first metal layer of the first circuit pattern layer 420 may satisfy a range of 0.5 um to 2.5 um.

If the thickness of the first metal layer of the first circuit pattern layer 420 is less than 0.2 um, the first metal layer of the first circuit pattern layer 420 may not function as a seed layer. If the thickness of the first metal layer of the first circuit pattern layer 420 is less than 0.2 um, it may be difficult to form a first metal layer with a uniform thickness on the upper surface of the insulating layer 410.

In addition, if the thickness of the first metal layer of the first circuit pattern layer 420 exceeds 3.0 um, a process time for forming the first metal layer of the first circuit pattern layer 420 may increase, and thus the yield may decrease. In addition, if the thickness of the first metal layer of the first circuit pattern layer 420 exceeds 3.0 um, an etching time of the first metal layer in the forming process of the first circuit pattern layer 420 may increase. In addition, if the thickness of the first metal layer of the first circuit pattern layer 420 exceeds 3.0 um, deformation of the second metal layer of the first circuit pattern layer 420 may occur when the first metal layer of the first circuit pattern layer 420 is etched. Here, deformation of the second metal layer of the first circuit pattern layer 420 may mean that a difference between a width of the upper surface and a width of the lower surface of the second metal layer increases as a side of the second metal layer is also etched when the first metal layer is etched. For example, deformation of the second metal layer of the first circuit pattern layer 420 may mean that a shape of a vertical cross-section of the second metal layer changes from a square to a trapezoidal shape.

In addition, if the thickness of the first metal layer of the first circuit pattern layer 420 exceeds 3.0 um, an etching amount in an etching process of the first metal layer increases, and accordingly, a depth of a dent (e.g., undercut) formed on the side of the first metal layer and the side of the second metal layer may increase. For example, if the etching amount in the etching process of the first metal layer increases, a difference between a width of the first metal layer and a width of the second metal layer may increase. In addition, if the difference between the width of the first metal layer and the width of the second metal layer increases, the electrical characteristics may deteriorate due to an increase in signal transmission loss. In addition, if the difference between the width of the first metal layer and the width of the second metal layer increases, dendrites may be formed by electromigration, and thereby the electrical characteristics and/or physical characteristics of the first circuit pattern layer 420 may deteriorate.

The second metal layer of the first circuit pattern layer 420 may be an electroplated layer in which the first metal layer is electroplated as a seed layer. The second metal layer of the first circuit pattern layer 420 may be formed on the first metal layer with a predetermined thickness. The second metal layer of the first circuit pattern layer 420 may include a same metal as the first metal layer of the first circuit pattern layer 420, but is not limited thereto. For example, the first metal layer and the second metal layer of the first circuit pattern layer 420 may each include copper.

A thickness of the second metal layer of the first circuit pattern layer 420 may be greater than the thickness of the first metal layer of the first circuit pattern layer 420.

The thickness of the second metal layer of the first circuit pattern layer 420 may satisfy a range of 3.5 µm to 25 µm. Preferably, the thickness of the second metal layer of the first circuit pattern layer 420 can satisfy a range of 4.0 µm to 23 µm. More preferably, the thickness of the second metal layer of the first circuit pattern layer 420 can satisfy a range of 4.5 µm to 22 µm.

If the thickness of the second metal layer of the first circuit pattern layer 420 is less than 3.5 µm, an etching of the second metal layer may also be performed during the etching process of the first metal layer. If the thickness of the second metal layer of the first circuit pattern layer 420 is less than 3.5 µm, an allowable current of a signal transmitted through the first circuit pattern layer may decrease, and thus the electrical characteristics may deteriorate. If the thickness of the second metal layer of the first circuit pattern layer 420 exceeds 25 µm, it may be difficult to miniaturize the first circuit pattern layer 420. For example, if the thickness of the second metal layer of the first circuit pattern layer 420 exceeds 25 µm, the width and spacing of the patterns constituting the first circuit pattern layer 420 may not satisfy required conditions. As a result, the circuit integration may decrease, or a volume of the circuit board and the semiconductor package may increase.

The circuit board 400 of the embodiment may include a second circuit pattern layer 430 disposed on a lower surface of the insulating layer 410. The second circuit pattern layer 430 may have a structure corresponding to the first circuit pattern layer 420. The second circuit pattern layer 430 may include at least one pad. For example, the second circuit pattern layer 430 may include a pad on which a semiconductor device is mounted. For example, the second circuit pattern layer 430 may include a pad to which an external substrate is coupled. As an example, the second circuit pattern layer 430 may include a pad to which a main board of an electronic device is coupled.

The second circuit pattern layer 430 may mean a second outermost circuit pattern layer of the circuit board 400. For example, when the circuit board 400 has a multilayer structure including a plurality of insulating layers, the second circuit pattern layer 430 may refer to a circuit pattern layer disposed on a lower surface of an insulating layer disposed at a lowermost side among the plurality of insulating layers.

Each of the first circuit pattern layer 420 and the second circuit pattern layer 430 may include a recess.

For example, the first circuit pattern layer 420 may include a first recess 420-1.

Specifically, the first circuit pattern layer 420 includes a pad and a trace connected to the pad. In addition, the pad of the first circuit pattern layer 420 has a first recess 420-1. The first recess 420-1 may be formed concavely from an upper surface of a pad of the first circuit pattern layer 420 toward a lower surface of the pad of the first circuit pattern layer 420.

The first recess 420-1 may refer to a concave portion formed on the upper surface of the pad of the first circuit pattern layer 420.

The first recess 420-1 may have different depths along a horizontal direction. For example, a bottom surface of the first recess 420-1 may have a concave-convex shape. Accordingly, an upper surface of the pad of the first circuit pattern layer 420 may have a concave-convex shape corresponding to the bottom surface of the first recess 420-1.

At this time, the first recess 420-1 may be provided entirely on the upper surface of the pad of the first circuit pattern layer 420, or differently, may be provided on a part of the upper surface of the pad of the first circuit pattern layer 420.

At least a part of the first recess 420-1 is vertically overlapped with the first protective layer 450 disposed on the insulating layer 410. Accordingly, at least a part of the upper surface of the pad of the first circuit pattern layer 420 may vertically overlap with the first protective layer 450 and not contact the first protective layer 450. For example, a crevice corresponding to the first recess 420-1 may be provided between an upper surface of the pad of the first circuit pattern layer 420 and a lower surface of the first protective layer 450.

Meanwhile, the first circuit pattern layer 420 includes a pattern other than the pad. At this time, the pad of the first circuit pattern layer 420 may mean a pattern vertically overlapping an opening 440-1 of the first protective layer 450 among the first circuit pattern layers 420, which will be described below. For example, the pad of the first circuit pattern layer 420 may mean a pattern including a region that vertically overlaps with the opening 440-1 of the first protective layer 450 among the first circuit pattern layer 420.

In addition, the pattern other than the pad of the first circuit pattern layer 420 may mean a pattern that does not vertically overlap with the opening 440-1 of the first protective layer 450 among the first circuit pattern layer 420. For example, an upper surface of the pattern other than the pad of the first circuit pattern layer 420 may be entirely covered by the first protective layer 450. In addition, the pattern other than the pad of the first circuit pattern layer 420 may include a trace.

In addition, the first recess may not be provided on an upper surface of the trace of the first circuit pattern layer 420. That is, the first recess 420-1 may be formed by processing a portion of the first circuit pattern layer 420 exposed through the opening 440-1 of the first protective layer 450 while the first protective layer 450 is formed. At this time, the trace of the first circuit pattern layer 420 is not exposed through the opening 440-1 of the first protective layer 450. That is, the trace of the first circuit pattern layer 420 may be entirely covered by the first protective layer 450. Therefore, the first recess may not be formed on the upper surface of the trace of the first circuit pattern layer 420.

Therefore, the first circuit pattern layer 420 may include patterns having different heights. For example, at least a portion of the upper surface of the pad of the first circuit pattern layer 420 may be positioned lower than an upper surface of the trace of the first circuit pattern layer 420. For example, the upper surface of the pad of the first circuit pattern layer 420 provided with the first recess 420-1 may be positioned lower than the upper surface of the trace not provided with the first recess. For example, the upper surface of the pad of the first circuit pattern layer 420 may be positioned lower than the upper surface of the trace of the first circuit pattern layer 420 by a depth of the first recess 420-1.

In addition, the second circuit pattern layer 430 may include a second recess 430-1.

Specifically, the second circuit pattern layer 430 includes a pad and a trace connected to the pad. In addition, the pad of the second circuit pattern layer 430 has a second recess 430-1. The second recess 430-1 may be formed convexly from a lower surface of the pad of the second circuit pattern layer 430 toward an upper surface of the pad of the second circuit pattern layer 430.

The second recess 430-1 may mean a convex portion formed on a lower surface of the pad of the second circuit pattern layer 430.

The second recess 430-1 may have different depths along a horizontal direction. For example, a bottom surface of the second recess 430-1 may have a concave-convex shape. Accordingly, a lower surface of the pad of the second circuit pattern layer 430 may have a concave-convex shape corresponding to the bottom surface of the second recess 430-1.

At this time, the second recess 430-1 may be provided entirely on the lower surface of the pad of the second circuit pattern layer 430, or alternatively, may be provided on a part of the lower surface of the pad of the second circuit pattern layer 430.

At least a part of the second recess 430-1 vertically overlaps with the second protective layer 460 disposed under the insulating layer 410. Accordingly, at least a part of the lower surface of the pad of the second circuit pattern layer 430 may vertically overlap with the second protective layer 460 and not contact the second protective layer 460. For example, a crevice corresponding to the second recess 430-1 may be provided between a lower surface of the pad of the second circuit pattern layer 430 and an upper surface of the second protective layer 460.

Meanwhile, the second circuit pattern layer 430 includes a pattern other than the pad. At this time, the pad of the second circuit pattern layer 430 may mean a pattern that vertically overlaps with an opening 460-1 of the second protective layer 460 to be described below among the second circuit pattern layer 430. For example, the pad of the second circuit pattern layer 430 may mean a pattern that includes a region that vertically overlaps with the opening 460-1 of the second protective layer 460 among the second circuit pattern layer 430.

In addition, the pattern other than the pad of the second circuit pattern layer 430 may mean a pattern that does not vertically overlap with the opening 460-1 of the second protective layer 460 among the second circuit pattern layer 430. For example, the lower surface of the pattern other than the pad of the second circuit pattern layer 430 may be entirely covered by the second protective layer 460. In addition, the pattern other than the pad of the second circuit pattern layer 430 may include a trace.

In addition, the second recess may not be formed on the lower surface of the trace of the second circuit pattern layer 430. That is, the second recess 430-1 may be formed by processing a part of the second circuit pattern layer 430 exposed through the opening of the second protective layer 460 while the second protective layer 460 is formed. At this time, the trace of the second circuit pattern layer 430 is not exposed through the opening 460-1 of the second protective layer 460. That is, the trace of the second circuit pattern layer 430 may be entirely covered by the second protective layer 460. Therefore, the second recess may not be formed on the lower surface of the trace of the second circuit pattern layer 430.

Accordingly, the second circuit pattern layer 430 may include patterns having different heights. For example, at least a portion of the lower surface of the pad of the second circuit pattern layer 430 may be positioned higher than the lower surface of the trace of the second circuit pattern layer 430. For example, the lower surface of the pad of the second circuit pattern layer 430 provided with the second recess 430-1 may be positioned higher than the lower surface of the trace not provided with the second recess. For example, the lower surface of the pad of the second circuit pattern layer 430 may be positioned lower than the lower surface of the trace of the second circuit pattern layer 430 by a depth of the second recess 430-1.

The recesses formed in each pad of the first circuit pattern layer 420 and the second circuit pattern layer 430 will be described in more detail below.

The circuit board 400 of the embodiment may include a through electrode 440. The through electrode 440 may penetrate the insulating layer 410. Preferably, the through electrode 440 can penetrate the insulating layer 410 to electrically connect between the first circuit pattern layer 420 and the second circuit pattern layer 430. At this time, when the circuit board 400 has a multi-layer structure, the through electrode 440 can electrically connect between adjacent circuit pattern layers while being spaced apart in a vertical direction.

The through electrode 440 can be formed by filling an inside of the through hole penetrating the insulating layer 410 with a conductive material.

The through hole can be formed by any one of mechanical, laser, and chemical processing methods. When the through hole is formed by mechanical processing, methods such as milling, drilling, and routing can be used. In addition, when the through hole is formed by laser processing, a UV or CO₂ laser method can be used. In addition, when the through hole is formed by chemical processing, a chemical agent including amino silane, ketones, etc. can be used.

The through electrode 440 includes a plurality of metal layers.

The through electrode 440 may include a first metal layer and a second metal layer corresponding to the first circuit pattern layer 420 and the second circuit pattern layer 430.

Meanwhile, in the above, the first circuit pattern layer 420 and the second circuit pattern layer 430 of the embodiment are described as including the first metal layer and the second metal layer because they are manufactured by a SAP process, but are not limited thereto.

For example, the first circuit pattern layer 420 and the second circuit pattern layer 430 may be manufactured by a MSAP process. Therefore, each of the first circuit pattern layer 420 and the second circuit pattern layer 430 may additionally have a third metal layer disposed between the first metal layer and the insulating layer. The third metal layer may refer to a copper layer attached during lamination of the insulating layer, but is not limited thereto.

Meanwhile, each of the first circuit pattern layer 420, the second circuit pattern layer 430, and the through electrode 440 may include a conductive material. For example, each of the first circuit pattern layer 420, the second circuit pattern layer 430, and the through electrode 440 may include at least one metal material selected from gold (Au), silver (Ag), platinum (Pt), titanium (Ti), tin (Sn), copper (Cu), and zinc (Zn). Preferably, each of the first circuit pattern layer 420, the second circuit pattern layer 430, and the through electrode 440 may be formed of copper (Cu) which has high electrical conductivity and is relatively inexpensive.

The first circuit pattern layer 420, second circuit pattern layer 430, and through electrode 440 can each be manufactured using conventional circuit board manufacturing processes such as additive process, subtractive process, MSAP (Modified Semi Additive Process), and SAP (Semi Additive Process), and a detailed description thereof is omitted here.

Meanwhile, the circuit board 400 of the embodiment may include a protective layer.

For example, the circuit board 400 may include a first protective layer 450 disposed on the insulating layer 410. For example, the circuit board 400 may include a second protective layer 460 disposed under the insulating layer 410.

The first protective layer 450 and the second protective layer 460 may be a resist layer. Preferably, the first protective layer 450 and the second protective layer 460 may be a solder resist layer containing an organic polymer material. For example, the first protective layer 450 and the second protective layer 460 may contain an epoxy acrylate series resin. In detail, the first protective layer 450 and the second protective layer 460 may contain a resin, a curing agent, a pigment, a solvent, a filler, an additive, an acrylic series monomer, etc.

A total thickness of each of the first protective layer 450 and the second protective layer 460 may be greater than a thickness of each of the first circuit pattern layer 420 and the second circuit pattern layer 430. The total thickness may mean a vertical distance between the lower surface and the upper surface of the first protective layer 450 and the second protective layer 460.

The total thickness of the first protective layer 450 may satisfy a range of 6.7 um to 35.0 um. Preferably, the total thickness of the first protective layer 450 may satisfy a range of 7.3 um to 32 um. More preferably, the total thickness of the first protective layer 450 may satisfy a range of 8.0 um to 30 um.

If the total thickness of the first protective layer 450 exceeds 30 um, the thickness of the circuit board and the thickness of the semiconductor package may increase. In addition, if the total thickness of the first protective layer 450 is less than 6.7 um, the first circuit pattern layer may not be stably protected, and thus, electrical reliability or physical reliability may be deteriorated.

In addition, the second protective layer 460 may have a thickness corresponding to the thickness of the first protective layer 450, but is not limited thereto.

The first protective layer 450 and the second protective layer 460 may each include an opening.

For example, the first protective layer 450 may include a first opening 450-1. The first opening 450-1 may vertically overlap at least a portion of the first circuit pattern layer 420. Accordingly, the first opening 450-1 of the first protective layer 450 may expose at least a portion of an upper surface of the first circuit pattern layer 420. Preferably, the first protective layer 450 may include a first opening 450-1 that vertically overlaps a pad of the first circuit pattern layer 420. In this case, a width of the first opening 450-1 may be smaller than a width of the pad of the first circuit pattern layer 420. Therefore, at least a portion of the pad of the first circuit pattern layer 420 may vertically overlap with the first opening 450-1 of the first protective layer 450, and a remaining portion of the pad of the first circuit pattern layer 420 may not vertically overlap with the first opening 450-1 of the first protective layer 450.

At least a portion of the first protective layer 450 may vertically overlap with the pad of the first circuit pattern layer 420 and not contact the pad of the first circuit pattern layer 420. For example, the first protective layer 450 may include an overlapping region that vertically overlaps with the pad of the first circuit pattern layer 420. In addition, at least a portion of the lower surface of the overlapping region of the first protective layer 450 may not contact the pad of the first circuit pattern layer 420. For example, at least a part of the lower surface of the overlapping region of the first protective layer 450 may vertically overlap with the first recess 420-1 formed on the upper surface of the pad of the first circuit pattern layer 420. Accordingly, a crevice may be provided between at least a part of the lower surface of the overlapping region of the first protective layer 450 and the upper surface of the pad of the first circuit pattern layer 420.

In addition, the second protective layer 460 may include a second opening 460-1. The second opening 460-1 may vertically overlap with at least a part of the second circuit pattern layer 430. Through this, the second opening 460-1 of the second protective layer 460 may expose at least a part of the lower surface of the second circuit pattern layer 430. Preferably, the second protective layer 460 may include a second opening 460-1 that vertically overlaps with the pad of the second circuit pattern layer 430. A width of the second opening 460-1 may be smaller than a width of the pad of the second circuit pattern layer 430. Accordingly, at least a portion of the pad of the first circuit pattern layer 430 may vertically overlap with the second opening 460-1 of the second protective layer 460, and a remaining portion of the pad of the first circuit pattern layer 430 may not vertically overlap with the second opening 460-1 of the second protective layer 460.

At least a portion of the second protective layer 460 may vertically overlap with the pad of the second circuit pattern layer 430 and not contact the pad of the second circuit pattern layer 430. For example, the second protective layer 460 may include an overlapping region that vertically overlaps the pad of the second circuit pattern layer 430. In addition, at least a portion of the upper surface of the overlapping region of the second protective layer 460 may not contact the pad of the second circuit pattern layer 430. For example, at least a portion of the upper surface of the overlapping region of the second protective layer 460 may vertically overlap with a second recess 430-1 formed on the lower surface of the pad of the second circuit pattern layer 430. Accordingly, a crevice may be provided between at least a portion of the upper surface of the overlapping region of the second protective layer 460 and the lower surface of the pad of the second circuit pattern layer 430.

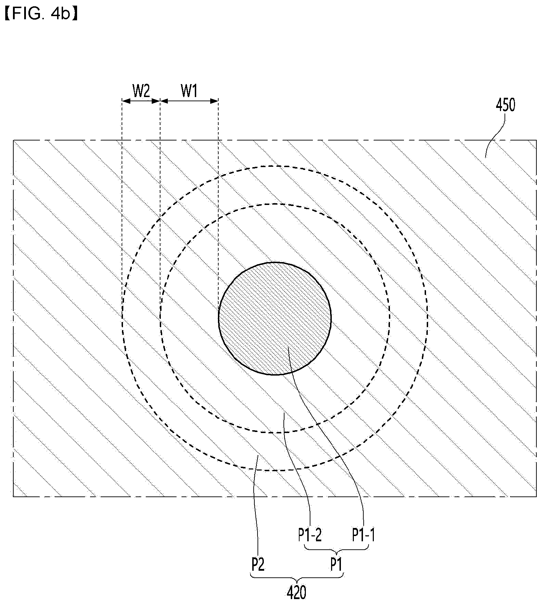

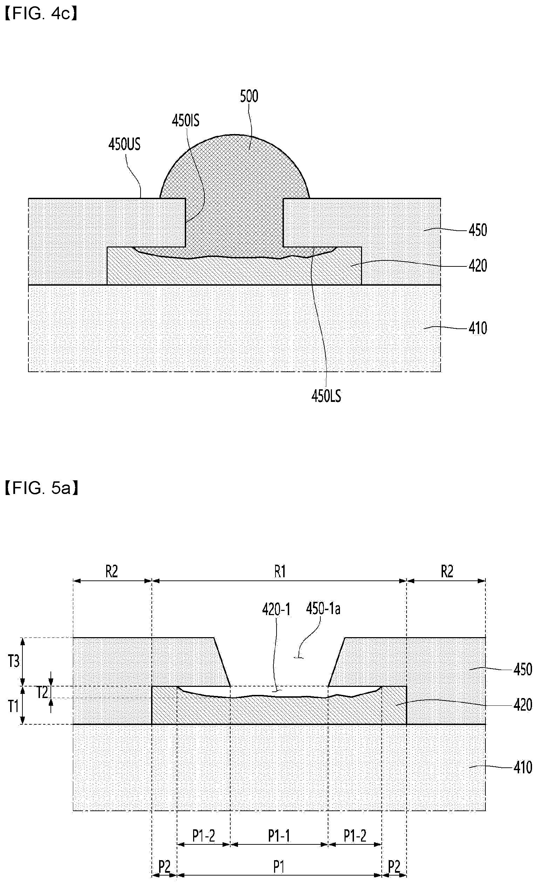

FIG. 4a is an enlarged cross-sectional view of a portion of a circuit board according to a first embodiment, FIG. 4b is a plan view of the circuit board of FIG. 4a, and FIG. 4c is a cross-sectional view showing a state in which a connecting member is disposed on the circuit board of FIG. 4a.

Hereinafter, with reference to FIGS. 4a to 4c, a pad, a recess formed on the pad, and a protective layer including an opening, provided on the circuit board of the first embodiment are specifically described.

The pad described below may mean a pad of the first circuit pattern layer 420, or, differently, a pad of the second circuit pattern layer 430. However, for the convenience of explanation, a description will be given by assigning the same as a drawing symbol of the pad as a drawing symbol of the first circuit pattern layer 420.

The circuit board of the first embodiment includes an insulating layer 410 and a pad 420 disposed on the insulating layer 410. The pad 420 may mean a pad of one of circuit pattern layers of the first circuit pattern layer and the second circuit pattern layer.

The pad 420 is disposed on the insulating layer 410. An upper surface of the pad 420 may have a step.

For example, the pad 420 may have a concave recess 420-1 formed from the upper surface of the pad 420 toward the lower surface of the pad 420. The recess 420-1 may also be referred to as a concave groove from the upper surface of the pad 420 toward the lower surface of the pad 420.

The recess 420-1 may be provided on a part of the upper surface of the pad 420. For example, the pad 420 may include a first portion P1 including the recess 420-1 and a second portion P2 not including the recess 420-1.

An upper surface of the first portion P1 of the pad 420 may be positioned lower than an upper surface of the second portion P2 of the pad 420. For example, the upper surface of the first portion P1 of the pad 420 may be positioned lower than the upper surface of the second portion P2 of the pad 420 by a depth corresponding to the recess 420-1.

The pad 420 may have a first thickness T1. Here, the first thickness T1 may mean a thickness of a portion having a largest thickness among an entire region of the pad 420. For example, the first thickness T1 of the pad 420 may mean a thickness of the second portion P2 of the pad 420. For example, the first thickness T1 of the pad 420 may mean a value that is a sum of a thickness of the first portion P1 of the pad 420 and a depth of the recess 420-1.

The first thickness T1 of the pad 420 may satisfy a range of 3.7um to 28um. For example, the first thickness T1 of the pad 420 may satisfy a range of 4.3um to 25.8um. For example, the first thickness T1 of the pad 420 may satisfy a range of 5um to 24.5um. Preferably, the first thickness T1 of the pad 420 may mean a sum of the thicknesses of the first metal layer and the second metal layer of the first circuit pattern layer 420 described above. In addition, if the first thickness T1 of the pad 420 is out of the above range, a previously described problem may occur.

At this time, the recess 420-1 may be provided with a certain depth on the upper surface of the first portion P1 of the pad 420.

The recess 420-1 may have a first depth T2. The first depth T2 may mean a difference value between a thickness of the first portion P1 of the pad 420 and a thickness of the second portion P2. At this time, the first portion P1 of the pad 420 has a concave-convex shape. Accordingly, the first portion P1 of the pad 420 has different thicknesses or heights in the horizontal direction. Accordingly, a thickness of the first portion P1 of the pad 420 may mean a thickness of a region having a smallest thickness among an entire region of the first portion P1. Alternatively, a thickness of the first portion P1 of the pad 420 may mean an average thickness of an entire region of the first portion P1.

In addition, the first depth T2 of the recess 420-1 and the difference value may mean a vertical separation distance from a lower surface of the first region R1 of the protective layer 450 described below to the upper surface of the first portion P1 of the pad 420. The vertical separation distance may mean a maximum vertical separation distance. For example, the vertical separation distance may mean a vertical distance from the upper surface of the first portion P1 of the pad 420 having a lowest height to a lower surface of the first region R1 of the protective layer 450. However, the embodiment is not limited thereto, and the vertical separation distance may mean an average separation distance.

Therefore, the first depth T2 of the recess 420-1 may have a same meaning as a thickness difference value between the first portion P1 and the second portion P2 of the pad 420 and the vertical separation distance.

The first depth T2 may have a range of 5% to 55% of the first thickness T1. Preferably, the first depth T2 may have a range of 7% to 52% of the first thickness T1. More preferably, the first depth T2 may have a range of 8% to 50% of the first thickness T1.

If the first depth T2 is less than 5% of the first thickness T1, an effect that may be derived from the recess 420-1 may be insignificant. That is, the recess 420-1 is provided to improve the bonding strength and adhesion between the connecting member 500 and the pad 420. At this time, if the first depth T2 is less than 5% of the first thickness T1, an effect of improving the bonding strength or adhesion may be insignificant. By this, a crack may occur in the connecting member 500, or a physical and/or electrical reliability problem may occur in which the connecting member 500 is separated from the pad 420.

If the first depth T2 exceeds 55% of the first thickness T1, an amount of the connecting member 500 filled in the recess 420-1 may increase. In addition, if the amount of the connecting member 500 increases, a rigidity of the connecting member 500 may weaken, and thus a crack may occur. In addition, if the first depth T2 exceeds 55% of the first thickness T1, a thickness deviation of the connecting member 500 may increase, and thus the connection reliability may deteriorate. In addition, if the first depth T2 exceeds 55% of the first thickness T1, the thickness deviation of the pad 420 for each region increases, and an electrical reliability problem may occur accordingly. For example, if the thickness deviation for each region increases, a transmission loss of a signal flowing through the pad 420 may increase, or an allowable current of the signal that can be provided through the pad 420 may decrease.

The protective layer 450 may include a plurality of regions.

For example, the protective layer 450 includes a first region R1 adjacent to the opening 450-1. That is, the protective layer 450 includes a first region R1 including the opening 450-1 and vertically overlapping the pad 420. In addition, the protective layer 450 may include a second region excluding the first region R1.

In addition, a lower surface of the first region R1 of the protective layer 450 can be divided into a plurality of lower surfaces. For example, the lower surface of the first region R1 of the protective layer 450 can include a first lower surface that does not contact the upper surface of the pad 420 and a second lower surface that contacts the upper surface of the pad 420.

Specifically, the lower surface of the first region R1 of the protective layer 450 includes a first lower surface that vertically overlaps the first portion P1 of the pad 420 and does not contact the first portion P1 of the pad 420 by the recess 420-1.

In addition, the lower surface of the first region R1 of the protective layer 450 includes a second lower surface that vertically overlaps the second portion P2 of the pad 420 and contacts the upper surface of the second portion P2.

That is, a crevice may be formed by the recess 420-1 between the upper surface of the first portion P1 of the pad 420 and the first lower surface of the first region R1 of the protective layer 450. In addition, the upper surface of the second portion P2 of the pad 420 and the second lower surface of the first region R1 of the protective layer 450 may directly contact each other.

The protective layer 450 may have a third thickness T3. At this time, the third thickness T3 may mean a thickness of the first region R1 of the protective layer 450.

Preferably, the third thickness T3 of the protective layer 450 may mean a vertical distance between the upper surface of the pad 420 and the upper surface of the protective layer 450.

The third thickness T3 of the protective layer 450 can satisfy a range of 1um to 25um. Preferably, the third thickness T3 of the protective layer 450 can satisfy a range of 3um to 18.5um. More preferably, the third thickness T3 of the protective layer 450 can satisfy a range of 3um to 16.5um. In addition, if the third thickness T3 of the protective layer 450 is out of the above range, as described above, the circuit pattern layer may not be stably protected or the overall thickness of the circuit board may increase.

Meanwhile, the first portion P1 of the pad 420 may be divided into a plurality of sub-portions. This may be divided based on a plurality of regions of the protective layer 450.

In addition, the upper surface of the first portion P1 of the pad 420 does not contact the protective layer 450. However, the upper surface of the first portion P1 of the pad 420 may include a first sub-portion P1-1 that does not vertically overlap with the first protective layer 450, and a second sub-portion P1-2 that is connected to the first sub-portion P1-1 and does not vertically overlap with the first portion P1.

That is, the first sub-portion P1-1 of the pad 420 may vertically overlap with an opening 450-1 provided in the protective layer 450. In addition, the second sub-portion P1-2 of the pad 420 may vertically overlap with a first region R1 of the protective layer 450 adjacent to the opening 450-1.

In other words, the pad 420 includes a first sub-portion P1-1 of the first portion P1 that vertically overlaps with the opening 450-1 of the protective layer 460. In addition, the pad 420 includes a second portion P2 and a second sub-portion P1-2 of the first portion P1 that vertically overlaps with the first region R1 of the protective layer 450.

At this time, the second sub-portion P1-2 of the first portion P1 and the second portion P2 vertically overlap with the first region R1 of the protective layer 450. At this time, the second sub-portion P1-2 of the first portion P1 has the recess 420-1. Accordingly, the upper surface of the second sub-portion P1-2 of the first portion P1 does not contact the lower surface of the first region R1 of the protective layer 450. In addition, the second portion P2 of the pad 420 does not have the recess 420-1. Therefore, the upper surface of the second portion P2 of the pad 420 is in direct contact with the lower surface of the first region R1 of the protective layer 450.

In summary, the second sub-portion P1-2 and the second portion P2 of the pad 420 of the embodiment vertically overlap with the first region R1 of the protective layer 450. At this time, the second sub-portion P1-2 of the pad is spaced apart from the protective layer 450, and the second portion P2 of the pad 420 is in direct contact with the protective layer 450.

At this time, a width W1 of the second sub-portion P1-2 of the pad 420 may be different from a width W2 of the second portion P2 of the pad 420. Preferably, the width W1 of the second sub-portion P1-2 of the pad 420 may be larger than the width W2 of the second portion P2 of the pad 420.

The width W1 of the second sub-portion P1-2 of the pad 420 may satisfy a range of 2 to 50 times the width W2 of the second portion P2 of the pad 420. Preferably, the width W1 of the second sub-portion P1-2 of the pad 420 may satisfy a range of 3 to 48 times the width W2 of the second portion P2 of the pad 420. More preferably, the width W1 of the second sub-portion P1-2 of the pad 420 can satisfy a range of 5 to 40 times the width W2 of the second portion P2 of the pad 420.

If the width W1 of the second sub-portion P1-2 of the pad 420 is less than twice the width W2 of the second portion P2 of the pad 420, an effect of increasing the adhesive strength and adhesion of the connecting member 500 is insufficient, and thus, a reliability problem may occur in which the connecting member 500 is separated from the pad 420.

In addition, if the width W1 of the second sub-portion P1-2 of the pad 420 exceeds 50 times the width W2 of the second portion P2 of the pad 420, an overall width of the pad 420 may increase accordingly. In addition, if the overall width of the pad 420 increases, the circuit integration may decrease, and accordingly, an overall volume of the circuit board may increase.

Meanwhile, if a center in a vertical direction of the opening 450-1 of the protective layer 450 and a center in a vertical direction of the pad 420 are aligned with each other, the second sub-portion P1-2 of the pad 420 may have a width corresponding to each other in an entire region. In addition, the second portion P2 of the pad 420 may also have a width corresponding to each other in the entire region. Here, having the corresponding width may mean that a width deviation in the entire region is 30% or less, 20% or less, 15% or less, 10% or less, 5% or less, or 2% or less. For example, having the corresponding width may mean that a difference between a maximum width and a minimum width in the entire region is 3 µm or less, 2 µm or less, 1 µm or less, or 0.5 µm or less.

Unlike this, if a center in a vertical direction of the opening 450-1 of the protective layer 450 and a center in a vertical direction of the pad 420 are misaligned, the second sub-portion P1-2 and the second portion P2 of the pad 420 may each have a different width in the entire region. In this case, the width W1 of the second sub-portion P1-2 and the width W2 of the second portion P2 may mean a width in one side portion that is adjacent to each other based on a vertical cross-section.

For example, the width W1 of the second sub-portion P1-2 may mean a width of a region adjacent to a first side of the first sub-portion P1-1 in the vertical cross section, and the width W2 of the second portion P2 may mean a width of a region adjacent to a first side of the second sub-portion P1-2.

Meanwhile, the connecting member 500 is disposed in the recess 420-1 and the opening 450-1.

Accordingly, the connecting member 500 may be divided into a plurality of parts.

For example, the connecting member 500 may include a first part disposed in the recess 420-1 of the pad 420. At this time, the first part of the connecting member 500 may be positioned between the first region R1 of the first protective layer 450 and the first portion P1 of the pad 420. Accordingly, the first part of the connecting member 500 may be in contact with a part 450LS of the lower surface of the first region R1 of the protective layer 450 and the upper surface of the first portion P1 of the pad 420.

In addition, the connecting member 500 may include a part positioned on the first part and disposed in the opening 450-1 of the protective layer 450. A second part of the connecting member 500 may have a shape corresponding to a shape of the opening 450-1. The second part of the connecting member 500 may be in contact with the inner surface 450IS of the first region R1 of the protective layer 450 forming the opening 450-1. At this time, a width of the opening 450-1 at a portion adjacent to the upper surface of the protective layer 450 and a width of the opening 450-1 at a portion adjacent to the lower surface of the protective layer 450 may be the same. Accordingly, the second part of the connecting member 500 may have a columnar shape in which the upper surface and the lower surface have a same width.

The connecting member 500 may include a third part disposed on the second part. The third part of the connecting member 500 may protrude on the upper surface of the protective layer 450. An upper surface of the third part of the connecting member 500 may have a curved surface convex in the upward direction. At least a part of the third part of the connecting member 500 may be positioned on the first region R1 of the protective layer 450. Therefore, the third part of the connecting member 500 may be in contact with an upper surface 450US of the first region R1 of the protective layer 450.

That is, an interface having a concave-convex shape may be provided between the connecting member 500 and the pad 420. At this time, the interface having the concave-convex shape may mean a lower surface of the connecting member 500. In contrast, the interface having the concave-convex shape may correspond to an upper surface of the first portion P1 of the pad 420. Accordingly, the interface having the concave-convex shape may have a structure of the first sub-portion P1-1 and the second sub-portion P1-2 of the first portion P1 of the pad 420.

The embodiment provides a recess 420-1 in the pad 420 as described above. In addition, the provided recess 420-1 can be used to improve the adhesion between the pad 420 and the connecting member 500. Specifically, the embodiment provides the connecting member 500 with an anchor structure and is coupled to the pad 420 by using the recess 420-1. Accordingly, the embodiment can improve the overall physical reliability and electrical reliability of the circuit board.

Meanwhile, although the recess 420-1 is described above as being applied to all pads of the first circuit pattern layer 420 and the second circuit pattern layer 430, the embodiment is not limited thereto. For example, it is possible to have an anchor structure including the recess 420-1 only for some pads having a relatively small size or having a low adhesion to the connecting member 500.

A circuit board and semiconductor package of the embodiment can improve an adhesion and a bonding strength between a pad and a connecting member. Therefore, the embodiment can solve a problem of cracks occurring in the connecting member, and thereby improve physical reliability and electrical reliability of the connecting member.

To this end, the circuit board of the embodiment includes an insulating layer, a pad, and a protective layer. The protective layer includes an opening vertically overlapping at least a portion of the pad. At this time, the protective layer includes a first region adjacent to the opening and vertically overlapping the pad, and a second region excluding the first region. In addition, the pad has a recess. The recess may be a concave portion that is concave from the upper surface of the pad toward the lower surface. The pad includes an upper surface having a concave-convex shape corresponding to the recess. At this time, the pad includes a first portion including the recess and a second portion that does not include the recess. At this time, the first portion of the pad includes a first sub-portion vertically overlapping the opening of the protective layer, and a second sub-portion vertically overlapping the first region of the protective layer. Meanwhile, a connecting member is disposed on the pad. At this time, the connecting member is disposed to fill the recess of the pad. Accordingly, the connecting member is disposed not only on the first sub-portion of the pad, but also on the second sub-portion. In addition, a part of the connecting member disposed on the second sub-portion may have a structure that is located between the lower surface of the first region of the protective layer and the upper surface of the second sub-portion of the pad.

Accordingly, the connecting member of the embodiment includes a first part disposed on the second sub-portion. In addition, the first part of the connecting member may function as an anchor that improves an adhesion and a bonding strength with the pad. Accordingly, the embodiment can solve a reliability problem of the connecting member being separated from the pad. Therefore, the embodiment can improve the overall product reliability of the circuit board and the semiconductor package.

In addition, the embodiment can improve a contact area between the pad and the connecting member through the anchor structure of the connecting member. Accordingly, the embodiment does not need to increase a size of the pad to improve the contact area. Accordingly, the embodiment can reduce a size of the pad, thereby improving a circuit integration. Furthermore, the embodiment can reduce an overall volume of the circuit board and the semiconductor package.

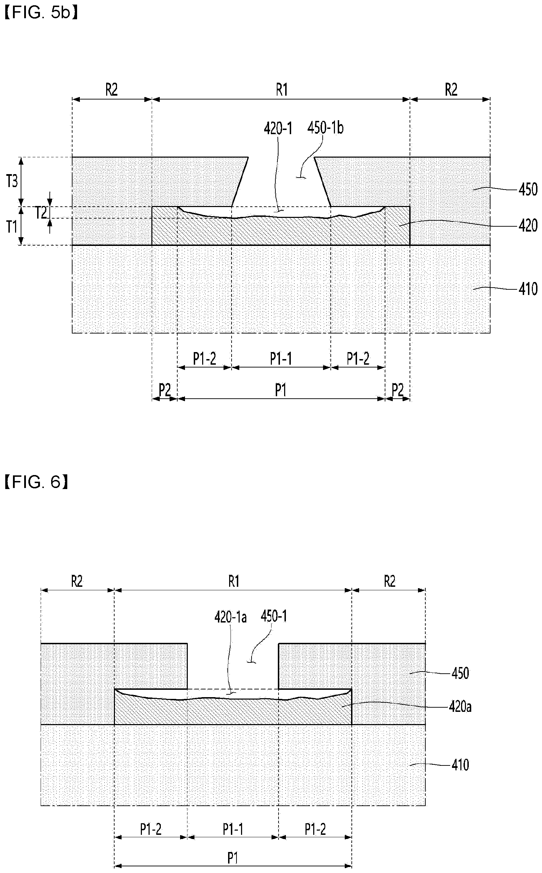

FIG. 5a is a view showing a first modified example of the circuit board of FIG. 4a, and FIG. 5b is a view showing a second modified example of the circuit board of FIG. 4a.

Hereinafter, first and second modified examples of the circuit board of the first embodiment will be described with reference to FIG. 5a and FIG. 5b. Meanwhile, in a description of the first and second modified examples, a description of the structure substantially the same as that of the circuit board of the first embodiment will be omitted.

The protective layer 450 of the circuit board of the first embodiment included an opening 450-1 vertically overlapping with the pad 420. At this time, the opening 450-1 had a shape with no change in width in the vertical direction. For example, a width of the opening 450-1 adjacent to the upper surface of the protective layer 450 was the same as a width of the opening 450-1 adjacent to the lower surface of the protective layer 450.

Unlike this, an opening of the protective layer 450 may have a width that changes in the vertical direction. For example, the opening of the protective layer 450 is formed through an exposure and development process. At this time, a shape in which the width of the opening is changed may vary according to exposure conditions. For example, the exposure conditions include a positive condition and a negative condition. In addition, the opening of the protective layer 450 may have different shapes depending on the exposure conditions.

Referring to FIG. 5a, the protective layer 450 may include an opening 450-1a.

The opening 450-1a of the protective layer 450 may include a region whose width changes.

For example, the opening 450-1a of the protective layer 450 may change in width from a region adjacent to the upper surface of the protective layer 450 to a region adjacent to the lower surface of the protective layer 450. For example, the opening 450-1a of the protective layer 450 may have a width that decreases from a region adjacent to the upper surface of the protective layer 450 to a region adjacent to the lower surface of the protective layer 450.

In addition, a pad 420 in the first modified example includes a first portion P1 including a recess 420-1 and a second portion P2 not including a recess. In addition, the first portion P1 of the pad 420 includes a first sub-portion P1-1 and a second sub-portion P1-2.

At this time, a width of the opening 450-1a changes along in a vertical direction. Therefore, a distinction between the first sub-portion P1-1 and the second sub-portion P1-2 of the pad 420 in the first modified example may be made based on a lower surface of the first region R1 of the protective layer 450.

The second sub-portion P1-2 of the pad 420 may mean a portion that includes the recess 420-1 and vertically overlaps with the lower surface of the first region R1 of the protective layer 450. In addition, the first sub-portion P1-1 of the pad 420 may mean a portion that vertically overlaps with the opening 450-1a of the protective layer 450 and does not vertically overlap with the lower surface of the first region R1 of the protective layer 450.

Referring to FIG. 5b, the protective layer 450 may include an opening 450-1b.

The opening 450-1b of the protective layer 450 may include a region whose width changes.

For example, the opening 450-1b of the protective layer 450 may change in width from a region adjacent to the upper surface of the protective layer 450 to a region adjacent to the lower surface of the protective layer 450. For example, the opening 450-1b of the protective layer 450 may increase in width from a region adjacent to the upper surface of the protective layer 450 to a region adjacent to the lower surface of the protective layer 450.

In addition, in the second modified example, the pad 420 includes a first portion P1 including a recess 420-1 and a second portion P2 not including a recess. In addition, the first portion P1 of the pad 420 includes a first sub-portion P1-1 and a second sub-portion P1-2.

At this time, the opening 450-1a changes in width vertically. Therefore, the distinction between the first sub-portion P1-1 and the second sub-portion P1-2 of the pad 420 in the first modified example can be made based on the lower surface of the first region R1 of the protective layer 450.

The second sub-portion P1-2 of the pad 420 can mean a portion that includes the recess 420-1 and vertically overlaps with the lower surface of the first region R1 of the protective layer 450. In addition, the first sub-portion P1-1 of the pad 420 can mean a portion that vertically overlaps with the opening 450-1b of the protective layer 450 and does not vertically overlap with the lower surface of the first region R1 of the protective layer 450.

Hereinafter, a circuit board of another embodiment will be described.

A circuit board described below has a structure similar to that of the circuit board of the first embodiment, and may have differences in recesses provided in the pads.

FIG. 6 is a cross-sectional view showing a circuit board of a second embodiment.

Referring to FIG. 6, the circuit board of the second embodiment includes an insulating layer 410, a pad 420a disposed on the insulating layer 410, and a protective layer 450 disposed on the insulating layer 410 and including an opening 450-1.

At this time, the pad 420a includes a recess 420-1a.

The recess 420-1a may be provided entirely on an upper surface of the pad 420a.

That is, the pad 420 of the circuit board of the first embodiment includes a first portion P1 having a recess and a second portion not having the recess.

In contrast, the pad 420a of the circuit board of the second embodiment may include only a first portion P1 having a recess 420-1a.

Accordingly, the pad 420a may include a first sub-portion P1-1 that vertically overlaps with the opening 450-1 of the protective layer 450, and a second sub-portion P1-2 that vertically overlaps with the lower surface of the first region R1 of the protective layer 450.

In addition, a lower surface of the first region R1 of the protective layer 450 may vertically overlap with the pad 420a and may not contact the pad 420a.

For example, an entire region of the upper surface of the pad 420a may not contact the protective layer 450.

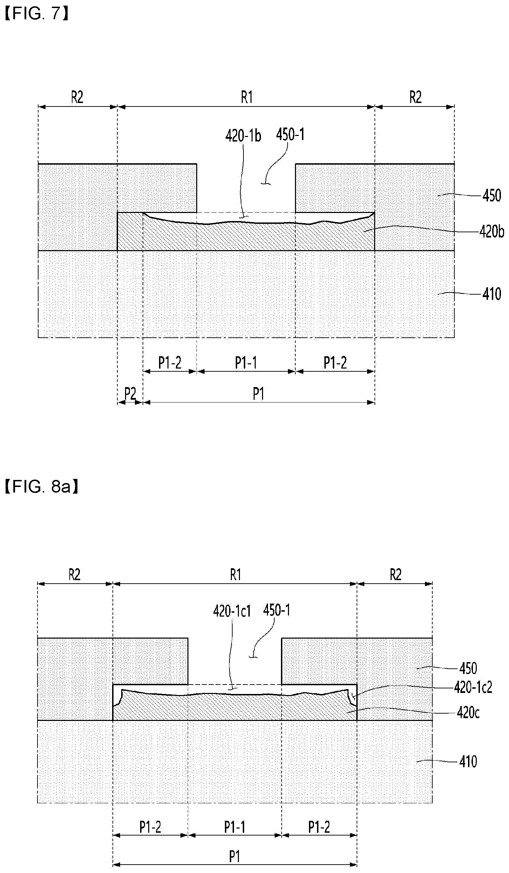

FIG. 7 is a cross-sectional view showing a circuit board of a third embodiment.

Referring to FIG. 7, the circuit board of the third embodiment includes an insulating layer 410, a pad 420b disposed on the insulating layer 410, and a protective layer 450 disposed on the insulating layer 410 and including an opening 450-1.

At this time, the pad 420b includes a recess 420-1b.

The recess 420-1b may be partially provided on an upper surface of the pad 420b.

The pad 420b includes a first portion P1 having the recess 420-1b and a second portion P2 not having the recess 420-1b. At this time, the second portion P2 of the pad 420b may be located only on one side of the first portion P1 of the pad 420b.

For example, the pad 420b may include a first side surface 420b and a second side surface opposite to the first side surface.

In addition, the second portion P2 of the pad 420b may not exist in a region adjacent to the first side surface of the pad 420b. For example, only the first portion P1 of the pad 420b may be located in a region adjacent to the first side surface of the pad 420b. For example, the first side surface of the pad 420b may be connected to the recess 420-1b. For example, the first side surface of the pad 420b may be directly connected to the second sub-portion P1-2 of the first portion P1 of the pad 420b. That is, the second portion P2 may not be located between the first side surface of the pad 420b and the second sub-portion P1-2.

In contrast, a second portion P2 of the pad 420b may exist in a region adjacent to a second side surface opposite to the first side surface of the pad 420b. For example, a second portion P2 connected to the second sub-portion P1-2 of the pad 420b may exist in a region adjacent to the second side surface of the pad 420b. Accordingly, the second side surface of the pad may not be connected to the recess 420-1b. For example, the second side surface of the pad 420b may not be directly connected to the first portion P1 of the pad 420b.

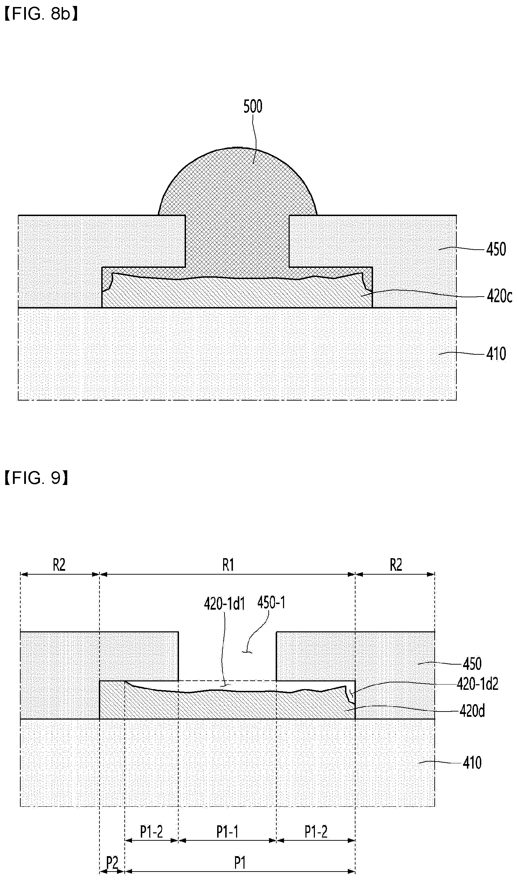

FIG. 8a is a drawing showing a circuit board according to a fourth embodiment, and FIG. 8b is a cross-sectional view showing a state in which a connecting member is disposed on the circuit board of FIG. 8a.

Referring to FIGS. 8a and 8b, the circuit board of the fourth embodiment includes an insulating layer 410, a pad 420c disposed on the insulating layer 410, and a protective layer 450 disposed on the insulating layer 410 and including an opening 450-1.

At this time, the pad 420c includes a recess.

The recess may be provided entirely on the upper surface of the pad 420c.

That is, the recess may include a first part 420-1c1 provided entirely on an upper surface of the pad 420c.

Differently, the pad 420c of the circuit board of the fourth embodiment includes a first part 420-1c1 of the recess, and thus, the pad 420c may include only a first portion P1. Accordingly, the upper surface of the pad 420c may not entirely contact the lower surface of the first region R1 of the protective layer 450.

Meanwhile, the recess may include a second part 420-1c2 connected to the first part 420-1c1.

The second part 420-1c2 may be formed on a side surface of the pad 420c while being connected to the first part 420-1c1.

In other words, the recess of the previous embodiment is provided only on the upper surface of the pad.

Differently, the recess of the fourth embodiment includes the first part 420-1c1 provided on the upper surface of the pad 420c and the second part 420-1c2 provided on the side surface of the pad 420c.

At this time, the recess of the fourth embodiment may be provided entirely on an entire region of the side surface of the pad 420c.

Therefore, at least a part of the side surface of the pad 420c may not be in contact with the first region R1 and the second region R2 of the protective layer 450 by the second part 420-1c2 of the recess, respectively.

In addition, the connecting member 500 is disposed in the first part 420-1c1 and the second part 420-1c2 of the recess 420-1b, respectively. The connecting member 500 may be in contact with the upper surface of the pad 420c and at least a part of the side surface of the pad 420c.

That is, the connecting member 500 may be in contact with the upper surface of the pad 420c and the lower surface of the first region R1 of the protective layer 450. In addition, the connecting member 500 can be in contact with the side surface of the pad 420c and the inner surface of the second region R2 of the protective layer 450. Through this, the embodiment can further improve the adhesion and bonding strength between the pad and the connecting member.

Meanwhile, the recess provided in the pad of the embodiment can include a plurality of parts. For example, the recess can include a first part provided on the upper surface of the pad and a second part connected to the first part and provided on the side surface of the pad.

Therefore, at least a part of the side surface of the pad can't be in contact with the protective layer through the second part of the recess. In addition, the connecting member can be disposed in the second part of the recess of the pad. The connecting member can be disposed in the first part of the recess and can be in contact with a lower surface of the first region of the protective layer and an upper surface of the pad. In addition, the connecting member may be positioned within the second part of the recess to be in contact with an inner surface of the second region of the protective layer and a side surface of the pad. Accordingly, the embodiment may further increase a contact area between the pad and the connecting member. Accordingly, the embodiment may further improve the adhesion and bonding strength between the pad and the connecting member.

FIG. 9 is a cross-sectional view showing a circuit board according to a fifth embodiment.

Referring to FIG. 9, a circuit board of the fifth embodiment includes an insulating layer 410, a pad 420d disposed on the insulating layer 410, and a protective layer 450 disposed on the insulating layer 410 and including an opening 450-1.

At this time, the pad 420d includes a recess.

The recess may be partially provided on the upper surface of the pad 420d.

In addition, the recess may be provided on a side surface of the pad 420d.

That is, the pad 420d may include a first part 420-1d1 partially provided on the upper surface of the pad 420d, and a second part 420-1d2 connected to the first part 420-1d1 and provided on the side surface of the pad 420d.

Meanwhile, the circuit board of the embodiment may be provided with a plurality of pads, and the plurality of pads may be provided with recesses having different shapes. For example, the circuit board of the embodiment may include recesses having different shapes described in at least two of the first to fifth embodiments. For example, the circuit board may include a first pad and a second pad. In addition, the first pad of the circuit board may be provided with a recess 420-1 of the first embodiment, and the second pad may be provided with a recess 420-1d1 and 420-1d2 of the fifth embodiment.

Hereinafter, a method for manufacturing a circuit board according to the embodiment will be described in orders of processes.

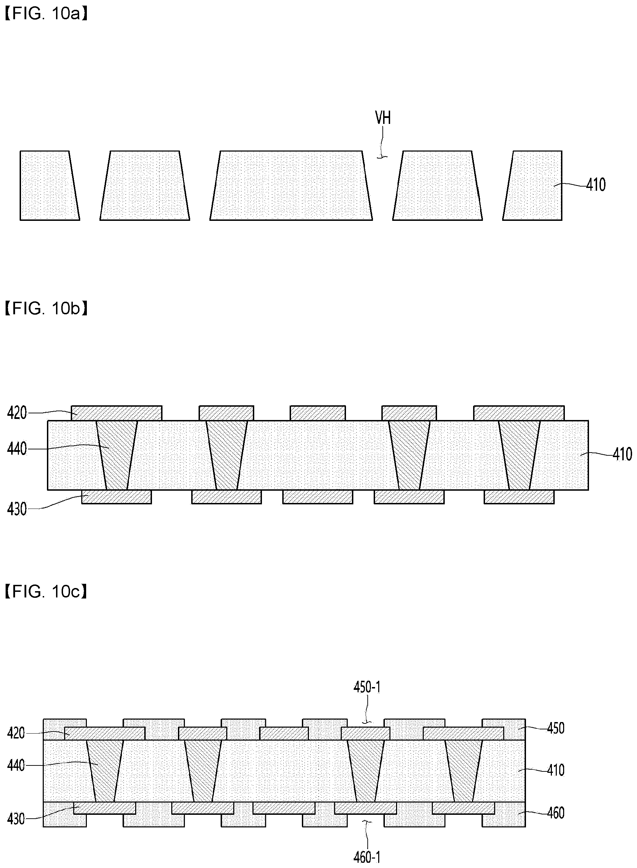

FIGS. 10a to 10d are cross-sectional views for explaining a method for manufacturing the circuit board illustrated in FIG. 3 in order of processes.

Referring to FIG. 10a, the embodiment prepares an insulating layer 410.

Thereafter, the embodiment forms a through hole VH penetrating the upper surface and the lower surface of the insulating layer 410.

Next, referring to FIG. 10b, the embodiment can form a through electrode 440 filling the through hole VH on the insulating layer 410. In addition, the embodiment can form a first circuit pattern layer 420 including at least one pad on the upper surface of the insulating layer 410. In addition, the embodiment can form a second circuit pattern layer 430 including at least one pad on the lower surface of the insulating layer 420.

Thereafter, referring to FIG. 10c, the embodiment can form a first protective layer 450 on the upper surface of the insulating layer 410. In addition, the embodiment can form a second protective layer 460 on the lower surface of the insulating layer 410.

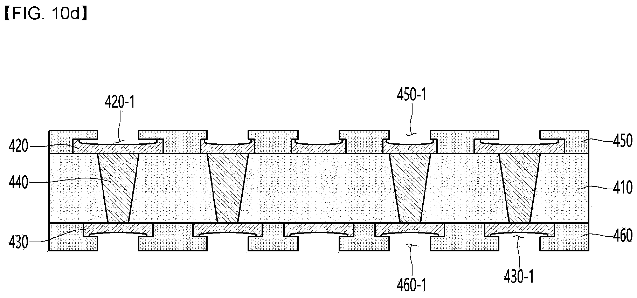

Next, referring to FIG. 10d, the embodiment can expose and develop each of the first protective layer 450 and the second protective layer 460. Through this, the embodiment can form an opening 450-1 vertically overlapping with a pad of the first circuit pattern layer 420 in the first protective layer 450. In addition, the embodiment can form an opening 460-1 vertically overlapping with a pad of the second circuit pattern layer 430 in the second protective layer 460.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

Features, structures, effects, etc. described in the above embodiments are included in at least one embodiment, and it is not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and variations should be interpreted as being included in the scope of the embodiments.

In the above, the embodiment has been mainly described, but this is only an example and does not limit the embodiment, and those of ordinary skill in the art to which the embodiment pertains will appreciate that various modifications and applications not illustrated above are possible without departing from the essential characteristics of the present embodiment. For example, each component specifically shown in the embodiment can be implemented by modification. In addition, the differences related to these modifications and applications should be interpreted as being included in the scope of the embodiments set forth in the appended claims.

## Claims

1. A circuit board comprising:
an insulating layer;
a circuit pattern layer disposed on the insulating layer and including a pad; and
a protective layer disposed on the insulating layer and including an opening vertically overlapping the pad,
wherein the pad includes a recess concave from an upper surface of the pad toward a lower surface of the pad,
wherein the protective layer includes a first region including the opening and vertically overlapping the pad, and a second region excluding the first region,
wherein the pad includes a first portion including the recess; and a second portion connected to the first portion and not having the recess,
wherein the first portion of the pad includes a first sub-portion vertically overlapping the opening of the protective layer, and a second sub-portion vertically overlapping a lower surface of the first region of the protective layer, and
wherein a width of the second sub-portion of the pad is greater than a width of the second portion of the pad.

2. The circuit board of claim 1, wherein an upper surface of the second sub-portion of the pad is spaced apart from the lower surface of the first region of the protective layer, and
wherein an upper surface of the second portion of the pad is in direct contact with the lower surface of the first region of the protective layer.

3. The circuit board of claim 1, wherein an upper surface of the first portion of the pad has a concave-convex shape.

4. The circuit board of claim 1, wherein the width of the second sub-portion of the pad satisfies a range of 2 to 50 times the width of the second portion of the pad.

5. The circuit board of claim 1, wherein a vertical distance from the lower surface of the first region of the protective layer to an upper surface of the first portion of the pad satisfies a range of 5% to 55% of a vertical distance from the lower surface of the first region of the protective layer to a lower surface of the pad.

6. The circuit board of any one of claims 1 to 5, wherein the pad includes a side surface, and
wherein at least a portion of an upper surface of the first portion of the pad is connected to the side surface of the pad.

7. The circuit board of any one of claims 1 to 5, wherein the recess of the pad is connected to a side surface of the pad.

8. The circuit board of any one of claims 1 to 5, wherein the pad includes a first side surface and a second side surface opposite to the first side surface, and
wherein a width of a second sub-portion of the pad adjacent to the first side surface of the pad is different from a width of a second sub-portion of the pad adjacent to the second side surface of the pad.

9. The circuit board of any one of claims 1 to 5, wherein the recess includes:
a first part provided on an upper surface of the pad; and
a second part provided on a side surface of the pad and connected to the first part.

10. The circuit board of claim 9, wherein a side surface of the pad having the second part is spaced apart from the protective layer.
